(19) Europäisches Patentamt
European Patent Office
Office européen des brevets

(11) **EP 4 321 930 A1**

(12) **EUROPEAN PATENT APPLICATION**

(43) Date of publication:
**14.02.2024 Bulletin 2024/07**

(21) Application number: **23189747.1**

(22) Date of filing: **04.08.2023**

(51) International Patent Classification (IPC):
**G03F 1/32** (2012.01)  **G03F 1/36** (2012.01)
**G03F 7/00** (2006.01)

(52) Cooperative Patent Classification (CPC):
**G03F 1/36; G03F 1/32; G03F 7/70433**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **08.08.2022 KR 20220098605**

(71) Applicant: **Samsung Display Co., Ltd.**
**Yongin-si, Gyeonggi-do 17113 (KR)**

(72) Inventors:
• **SO, SOON-HWAN**
**Giheung-Gu, Yongin-si, Gyeonggi-Do (KR)**
• **KIM, TAE JOON**
**Giheung-gu, Yongin-si, Gyeonggi-do (KR)**
• **YU, WONSEON**
**Giheung-Gu, Yongin-si, Gyeonggi-Do (KR)**
• **KIM, BONG YEON**
**Giheung-Gu, Yongin-si, Gyeonggi-Do (KR)**
• **CHO, SUNG-WOO**
**Giheung-Gu, Yongin-si, Gyeonggi-Do (KR)**

(74) Representative: **Dr. Weitzel & Partner**
**Patent- und Rechtsanwälte mbB**
**Friedenstrasse 10**
**89522 Heidenheim (DE)**

(54) **PHOTOMASK AND METHOD OF MANUFACTURING DISPLAY PANEL USING THE SAME**

(57)    A photomask includes a first light-transmitting portion including first and second main patterns spaced apart from each other in a first direction, a second light-transmitting portion having a light transmittance lower than a light transmittance of the first light-transmitting portion and including a first auxiliary pattern disposed between the first and second main patterns and extending in a second direction crossing the first direction, a second auxiliary pattern spaced apart from the first auxiliary pattern in the first direction with the first main pattern interposed therebetween and surrounding the first main pattern, and a third auxiliary pattern spaced apart from the first auxiliary pattern in the first direction with the second main pattern interposed therebetween and surrounding the second main pattern, and a light shielding portion surrounding the first and second light-transmitting portions.

FIG. 1C

## Description

### BACKGROUND

#### 1. Field of disclosure

The present invention relates to a photomask and a method of manufacturing a display panel using the photomask. More particularly, the invention relates to a photomask capable of increasing a resolution of an exposure pattern and a method of manufacturing a display panel using the photomask.

#### 2. Description of the Related Art

Multimedia devices, such as televisions, mobile phones, tablet computers, computers, navigation devices, and game devices, include a display panel displaying an image. The display panel includes pixels generating the image, and each of the pixels includes a light emitting element emitting a light and a circuit element connected to the light emitting element.

### SUMMARY

In recent years, demands for display panels with high resolution are increasing. Accordingly, patterns in a display panel with high resolution also become finer, and researches are desired to improve an exposure resolution and an exposure reliability of a photomask used to manufacture the display panel. The present invention is defined by the features of the independent claims. The dependent claims describe preferred embodiments.

The invention provides a photomask capable of increasing a resolution of an exposure pattern and an exposure reliability.

The invention provides a method of manufacturing a display panel using the photomask, which is capable of increasing a resolution of a contact hole in an insulating layer and forming a contact hole with improved reliability.

Embodiments of the invention provide a photomask, which may be used to manufacture a display panel, including a first light-transmitting portion including first and second main patterns spaced apart from each other in a first direction, a second light-transmitting portion having a light transmittance lower than a light transmittance of the first light-transmitting portion and including a first auxiliary pattern disposed between the first and second main patterns and extending in a second direction crossing the first direction, a second auxiliary pattern spaced apart from the first auxiliary pattern in the first direction with the first main pattern interposed therebetween and surrounding the first main pattern, and a third auxiliary pattern spaced apart from the first auxiliary pattern in the first direction with the second main pattern interposed therebetween and surrounding the second main pattern, and a light shielding portion surrounding the first and second light-transmitting portions. In such an embodiment, the first auxiliary pattern, the first main pattern, and the second auxiliary pattern satisfy the following Equation: $l \geq h + s$, where $l$ denotes a length in the second direction of the first auxiliary pattern, $h$ denotes a maximum width in one of the first and second directions of the first main pattern, and $s$ denotes a separation distance in the first direction between the first main pattern and the second auxiliary pattern.

In an embodiment, the second auxiliary pattern may include a first sub-pattern extending in the first direction, a second sub-pattern extending in the first direction and spaced apart from the first sub-pattern in the second direction with the first main pattern interposed therebetween, and a third sub-pattern extending in the second direction. In such an embodiment, the third auxiliary pattern may include a fourth sub-pattern extending in the first direction, a fifth sub-pattern extending in the first direction and spaced apart from the fourth sub-pattern in the second direction with the second main pattern interposed therebetween, and a sixth sub-pattern extending in the second direction and spaced apart from the first auxiliary pattern with the second main pattern interposed therebetween in the first direction.

In an embodiment, the first, second and third sub-patterns may be integrally formed with each other as a single unitary and indivisible part or are spaced apart from each other.

In an embodiment, the second auxiliary pattern may further include a first additional sub-pattern extending from one end of the first sub-pattern to one end of the third sub-pattern in an oblique direction of the first direction and a second additional sub-pattern extending from one end of the second sub-pattern to another end of the third sub-pattern in a direction crossing the oblique direction.

In an embodiment, the first auxiliary pattern may have a rectangular shape.

In an embodiment, The photomask may further include a third main pattern spaced apart from the first auxiliary pattern in the second direction, a first additional auxiliary pattern extending in the first direction, disposed between the first auxiliary pattern and the third main pattern, and spaced apart from the first, second and third auxiliary patterns, and a second additional auxiliary pattern spaced apart from the first additional auxiliary pattern in the second direction with the third main pattern interposed therebetween and surrounding the third main pattern.

In an embodiment, the second additional auxiliary pattern includes a seventh sub-pattern extending in the second direction, an eighth sub-pattern extending in the second direction and spaced apart from the seventh sub-pattern in the first direction with the third main pattern interposed therebetween, and a ninth sub-pattern extending in the first direction.

In an embodiment, the seventh, eighth and ninth sub-patterns may be integrally formed with each other as a single unitary and indivisible part or may be spaced apart from each other.

In an embodiment, the second additional auxiliary pattern may further include a fifth additional sub-pattern extending from one end of the seventh sub-pattern to one end of the ninth sub-pattern in an oblique direction of the first direction and a sixth additional sub-pattern extending from one end of the eighth sub-pattern to another end of the ninth sub-pattern in a direction crossing the oblique direction.

In an embodiment, the photomask may further include a third main pattern spaced apart from the first main pattern in the second direction, a fourth main pattern spaced apart from the second main pattern in the second direction, a first additional auxiliary pattern extending in the first direction, disposed between the first and third main patterns, and spaced apart from the first, second and third auxiliary patterns, a second additional auxiliary pattern extending in the first direction, disposed between the second and fourth main patterns, and spaced apart from the first, second and third auxiliary patterns, a third additional auxiliary pattern extending in the second direction and disposed between the third and fourth main patterns, a fourth additional auxiliary pattern spaced apart from the first additional auxiliary pattern in the second direction with the third main pattern interposed therebetween and surrounding the third main pattern, and a fifth additional auxiliary pattern spaced apart from the second additional auxiliary pattern in the second direction with the fourth main pattern interposed therebetween and surrounding the fourth main pattern.

In an embodiment, the second auxiliary pattern may include a first sub-pattern extending in the first direction and spaced apart from the first additional auxiliary pattern in the second direction with the first main pattern interposed therebetween and a second sub-pattern extending in the second direction. In such an embodiment, the fourth additional auxiliary pattern may further include a fifth sub-pattern extending in the first direction and spaced apart from the first additional auxiliary pattern in the second direction with the third main pattern interposed therebetween and a sixth sub-pattern extending in the second direction.

In an embodiment, the first and second sub-patterns may be integrally formed with each other as a single unitary and indivisible part, and the fifth and sixth sub-patterns may be integrally formed with each other as a single unitary and indivisible part.

In an embodiment, the first and second sub-patterns may be spaced apart from each other, and the fifth and sixth sub-patterns may be spaced apart from each other.

In an embodiment, the fourth additional auxiliary pattern may further include a third additional sub-pattern extending from one end of the fifth sub-pattern to one end of the sixth sub-pattern in an oblique direction of the first direction, and the second auxiliary pattern may further include a first additional sub-pattern extending from one end of the first sub-pattern to one end of the second sub-pattern in a direction crossing the oblique direction.

In an embodiment, the first auxiliary pattern and the first, second and third additional auxiliary patterns may be spaced apart from each other.

In an embodiment, the first auxiliary pattern and the third additional auxiliary pattern are integrally formed with each other as a single unitary and indivisible part or the first additional auxiliary pattern and the second additional auxiliary pattern are integrally formed with each other as a single unitary and indivisible part.

In an embodiment, each of the first and second main patterns may have a quadrangular shape or an octagonal shape.

In an embodiment, the photomask may further include a transparent base substrate, a light transmitting layer having a light transmittance lower than a light transmittance of the transparent base substrate, and disposed on the transparent base substrate, where first and second main openings are defined through the light transmitting layer, and a light blocking layer disposed on the light transmitting layer, where a third main opening corresponding to the first main opening, a fourth main opening corresponding to the second main opening, and first, second and third auxiliary openings are defined through the light blocking layer. In such an embodiment, portions of the transparent base substrate, which are exposed through the first and third main openings, may correspond to the first main pattern, portions of the transparent base substrate, which are exposed through the second and fourth main openings, may correspond to the second main pattern, a portion of the light transmitting layer, which is exposed through the first auxiliary opening, may correspond to the first auxiliary pattern, a portion of the light transmitting layer, which is exposed through the second auxiliary opening, may correspond to the second auxiliary pattern, and a portion of the light transmitting layer, which is exposed through the third auxiliary opening, may correspond to the third auxiliary pattern.

In an embodiment, the light transmitting layer may include at least one selected from Mo, Si, and Cr.

In an embodiment, the second light-transmitting portion may have a light transmittance equal to or greater than about 3% and equal to or smaller than about 60%.

In an embodiment, a phase of a light passing through the second light-transmitting portion may be changed by about 100 degrees or more and about 300 degrees or less.

In an embodiment, the first and second main patterns and the second auxiliary pattern satisfy the following Equation: $2s \le w \le h+2(s+p)$, where w denotes a separation distance between the first and second main patterns, and p denotes a minimum width in the first direction of the second auxiliary pattern.

In an embodiment, the first and second auxiliary patterns satisfy the following Equation of $d1 \ge 0.5s$, where d1 denotes a separation distance between the first and second auxiliary patterns, the first and third auxiliary patterns satisfy the following Equation of d2 ≥ 0.5s, and d2 denotes a separation distance between the first and third auxiliary patterns.

Embodiments of the invention provide a photomask, which may be used to manufacture a display device, including a base substrate, a lower layer disposed on the base substrate, where first and second main openings spaced apart from each other in a first direction are defined through the lower layer, and an upper layer disposed on the lower layer, where a third main opening corresponding to the first main opening, a fourth main opening corresponding to the second main opening, a first auxiliary opening disposed between the third and fourth main openings and extending in a second direction crossing the first direction when viewed in a plan view, a second auxiliary opening spaced apart from the first auxiliary opening with the third main opening interposed therebetween in the first direction and surrounding the third main opening, and a third auxiliary opening spaced apart from the first auxiliary opening with the fourth main opening interposed therebetween in the first direction and surrounding the fourth main opening are defined through the upper layer. In such an embodiment, the first auxiliary opening, the third main opening, and the second auxiliary opening satisfy the following Equation: l > h + s, where l denotes a length in the second direction of the first auxiliary opening, h denotes a maximum width in one of the first and second directions of the third main opening, and s denotes a separation distance in the first direction between the third main opening and the second auxiliary opening.

In an embodiment, the lower layer may have a light transmittance lower than a light transmittance of the base substrate, and a phase of a light passing through the lower layer may be changed.

Embodiments of the invention provide a method of manufacturing a display panel. In such embodiments, the manufacturing method includes preparing a preliminary display panel including a base layer, a conductive pattern disposed on the base layer, at least one insulating layer disposed on the conductive pattern, and a resist layer disposed on the at least one insulating layer, placing a photomask on the preliminary display panel, where the photomask includes a first light-transmitting portion including first and second main patterns spaced apart from each other in a first direction, a second light-transmitting portion spaced apart from the first light-transmitting portion and having a light transmittance lower than a light transmittance of the first light-transmitting portion, and a light shielding portion surrounding the first and second light-transmitting portions, radiating a light to the photomask to pattern the resist layer such that first and second exposure openings are formed through the resist layer to respectively correspond to the first and second main patterns, and patterning the at least one insulating layer to form first and second contact holes through the at least one insulating layer to respectively correspond to the first and second exposure openings. In such embodiments, the second light-transmitting portion of the photomask includes a first auxiliary pattern disposed between the first and second main patterns and extending in a second direction crossing the first direction, a second auxiliary pattern spaced apart from the first auxiliary pattern in the first direction with the first main pattern interposed therebetween, and a third auxiliary pattern spaced apart from the first auxiliary pattern in the first direction with the second main pattern interposed therebetween. In such embodiments, the first auxiliary pattern, the first main pattern, and the second auxiliary pattern satisfy the following Equation: l > h + s, where l denotes a length in the second direction of the first auxiliary pattern, h denotes a maximum width in one of the first and second directions of the first main pattern, and s denotes a separation distance in the first direction between the first main pattern and the second auxiliary pattern.

According to embodiments of the invention, as described herein, as auxiliary patterns having a predetermined shape and arrangement are applied to the exposure patterns adjacent thereto, the resolution of the exposure pattern increases, and the exposure reliability of the photomask is improved.

According to embodiments of the invention, as described herein, as the photomask, which includes the exposure pattern with increased resolution and has improved exposure reliability with auxiliary patterns adjacent thereto, is used in the manufacturing of the display panel, the resolution of the contact hole increases, and the reliability of the contact hole is improved. Accordingly, the process reliability and the process efficiency of the manufacturing method of the display panel are improved.

BRIEF DESCRIPTION OF THE DRAWINGS

The above and other features of embodiments of the invention will become readily apparent by reference to the following detailed description when considered in conjunction with the accompanying drawings, in which:

    FIG. 1A is a perspective view of a photomask according to an embodiment of the invention;
    FIG. 1B is a cross-sectional view of the photomask taken along line I-I' of FIG. 1A;
    FIG. 1C is an enlarged plan view of the photomask in an area PP' of FIG. 1A according to an embodiment of the invention;
    FIG. 2A is a perspective view of a display panel according to an embodiment of the invention;
    FIG. 2B is an enlarged cross-sectional view of a portion of a display panel according to an embodiment of the invention;
    FIG. 3A is a perspective view of a process of a method of manufacturing a display panel according to an embodiment of the invention;
    FIGS. 3B to 3G are cross-sectional views of processes of a method of manufacturing a display panel according to an embodiment of the invention;

FIG. 3H is an enlarged plan view of a process of a method of manufacturing a display panel according to an embodiment of the invention;

FIG. 3I is a cross-sectional view of a process of a method of manufacturing a display panel according to an embodiment of the invention;

FIG. 4A is an enlarged plan view of a portion of a photomask in an area AA' of FIG. 1C according to an embodiment of the invention;

FIG. 4B is a cross-sectional view of the photomask taken along line II-II' of FIG. 4A according to an embodiment of the invention;

FIG. 4C is a cross-sectional view of the photomask taken along line III-III' of FIG. 4A according to an embodiment of the invention;

FIG. 4D is an enlarged plan view of a portion of the photomask according to an embodiment of the invention;

FIG. 5 is an enlarged plan view of a portion of a photomask according to an embodiment of the invention;

FIGS. 6A and 6B are enlarged plan views of portions of photomasks according to embodiments of the invention;

FIG. 7A is an enlarged plan view of a portion of a photomask in an area BB' of FIG. 1C according to an embodiment of the invention;

FIGS. 7B and 7C are enlarged plan views of portions of photomasks according to embodiments of the invention;

FIG. 8A is an enlarged plan view of a portion of a photomask in an area CC' of FIG. 1C according to an embodiment of the invention;

FIGS. 8B and 8C are enlarged plan views of portions of photomasks according to embodiments of the invention; and

FIGS. 9A and 9B are enlarged plan views of portions of photomasks according to embodiments of the invention.

## DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

In the disclosure, it will be understood that when an element (or area, layer, or portion) is referred to as being "on", "connected to" or "coupled to" another element or layer, it can be directly on, connected or coupled to the other element or layer or intervening elements or layers may be present.

Like numerals refer to like elements throughout. In the drawings, the thickness, ratio, and dimension of components are exaggerated for effective description of the technical content. "Or" means "and/or." As used herein, the term "and/or" may include any and all combinations of one or more of the associated listed items.

It will be understood that, although the terms first, second, etc. may be used herein to describe various elements, these elements should not be limited by these terms. These terms are only used to distinguish one element from another element. Thus, a first element discussed below could be termed a second element without departing from the teachings of the invention. As used herein, the singular forms, "a", "an" and "the" are intended to include the plural forms as well, unless the context clearly indicates otherwise. For example, "an element" has the same meaning as "at least one element," unless the context clearly indicates otherwise. "At least one" is not to be construed as limiting "a" or "an."

Spatially relative terms, such as "beneath", "below", "lower", "above", "upper" and the like, may be used herein for ease of description to describe one element or feature's relationship to another elements or features as shown in the figures.

It will be further understood that the terms "comprises" and/or "comprising," or "include" and/or "including", when used in this specification, specify the presence of stated features, integers, steps, operations, elements, and/or components, but do not preclude the presence or addition of one or more other features, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms including technical and scientific terms used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the invention will be described in detail with reference to the accompanying drawings.

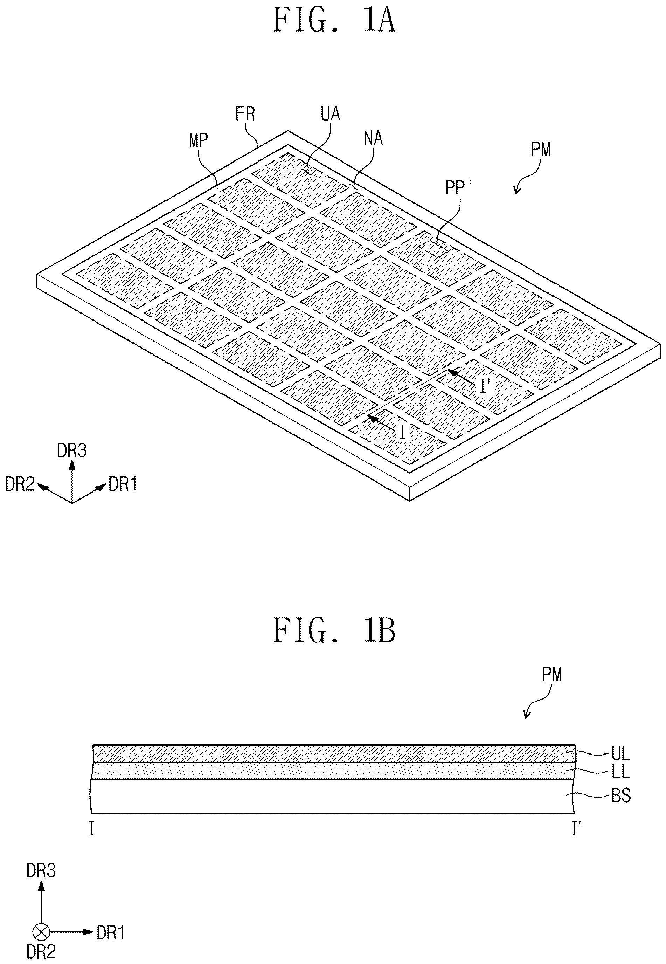

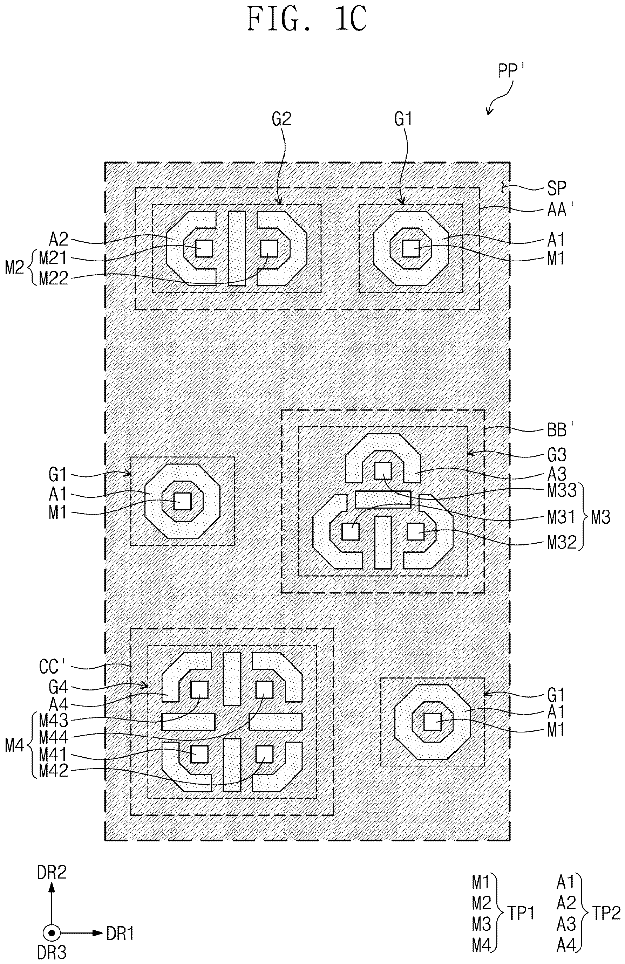

FIG. 1A is a perspective view of a photomask PM according to an embodiment of the invention. FIG. 1B is a cross-sectional view of the photomask PM taken along line I-I' of FIG. 1A. FIG. 1C is an enlarged plan view of the photomask PM in an area PP' of FIG. 1A according to an embodiment of the invention.

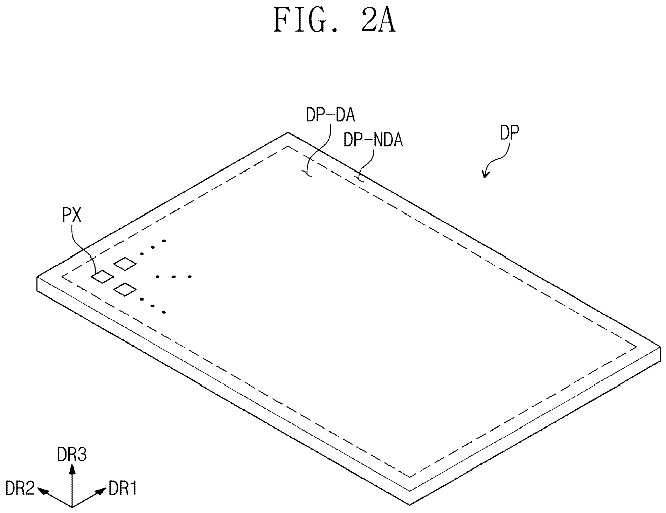

In an embodiment, the photomask PM may be a photomask used to manufacture a display panel DP (refer to FIG. 2A). The photomask PM may include a substrate including or formed of a transparent material that transmits an exposure light and patterns formed on the substrate to control the transmission of the exposure light. A resist layer that is patterned through an exposure process and a development process using the photomask PM may be formed, and desired patterns may be formed in the display panel DP (refer to FIG. 2A) through an etching process using the patterned resist layer. In an embodiment, for example, the patterns to be formed in the display panel DP (refer to FIG. 2A) may be contact holes defined through an insulating layer to expose portions of a conductive pattern.

Referring to FIG. 1A, the photomask PM may have a rectangular shape with short sides extending in a first direction DR1 and long sides extending in a second direction DR2 crossing the first direction DR1. However, the shape of the photomask PM should not be limited to the rectangular shape, and the photomask PM may have a variety of shapes, such as a circular shape, a polygonal shape, etc.

In an embodiment, the exposure light may be radiated to an upper surface of the photomask PM in a direction, which is substantially perpendicular to a plane defined by the first direction DR1 and the second direction DR2. A normal line direction of the upper surface of the photomask PM may be substantially parallel to a third direction DR3, and a lower surface of the photomask PM may be opposite to the upper surface of the photomask PM in the third direction DR3. A separation distance between the upper and lower surfaces in the third direction DR3 may correspond to a thickness of a member (or a unit) in the third direction DR3. The exposure light may be radiated in a direction opposite to the third direction DR3 from a position above the upper surface of the photomask PM.

The photomask PM may include a mask portion MP and a frame portion FR. The mask portion MP may include a plurality of unit areas UA and a peripheral area NA surrounding the unit areas UA. The unit areas UA may be arranged in the first direction DR1 and the second direction DR2. However, this is merely an example, and the arrangement of the unit areas UA should not be particularly limited.

Each of the unit areas UA may have a quadrangular shape. In an embodiment, the shape of each of the unit areas UA may correspond to a shape of the display panel DP (refer to FIG. 2A) to be manufactured using the photomask PM. Accordingly, the shape of the unit areas UA should not be particularly limited and may vary depending on the shape of the display panel DP (refer to FIG. 2A) to be manufactured.

According to an embodiment of the invention, the unit areas UA may include main patterns and auxiliary patterns described later. The unit areas UA may be defined as unit areas in which the main patterns and the auxiliary patterns with a predetermined shape and arrangement are repeated.

The main patterns may determine areas through which a light is transferred to the resist layer during the exposure process and may determine the patterns formed in the display panel DP (refer to FIG. 2A). The auxiliary patterns may be arranged adjacent to the main patterns and may increase an intensity of the light transferred to the resist layer, and thus, the precision of the patterns formed in the display panel DP (refer to FIG. 2A) may increase.

The frame portion FR may surround the mask portion MP. The frame portion FR may include stick portions (or bar-shaped portions) extending in the first direction DR1 and stick portions extending in the second direction DR2. The stick portions extending in the first direction DR1 and the second direction DR2 may be connected to each other and may cover edges of the mask portion MP. The frame portion FR may include a material with relatively high rigidity. The frame portion FR may absorb impacts applied to the mask portion MP from the outside to protect the mask portion MP. Alternatively, the frame portion FR may be omitted.

Referring to FIG. 1B, in an embodiment, the photomask PM may include a base substrate BS, a lower layer LL, and an upper layer UL.

The base substrate BS may be a transparent substrate. The base substrate BS may be referred to as a transparent base substrate. The base substrate BS may include a transparent material that transmits the exposure light. According to an embodiment, the base substrate BS may include quartz, however, the material for the base substrate BS should not be particularly limited as long as the material for the base substrate BS is transparent.

The lower layer LL may be disposed on the base substrate BS. The lower layer LL may have a light transmittance lower than that of the base substrate BS. According to an embodiment, the transmittance of the lower layer LL with respect to the light having a wavelength (single wavelength or complex wavelength) of a D-UV ray (equal to or greater than about 260 nanometers (nm) and equal to or smaller than a wavelength of i-ray), i-ray, h-ray, and g-ray may be equal to or greater than about 3% and equal to or smaller than about 60%. The lower layer LL may be referred to as a light transmitting layer.

The lower layer LL may change a phase of the light. According to an embodiment, the lower layer LL may change the phase of the light having the wavelength (single wavelength or complex wavelength) of the D-UV ray (equal to or greater than about 260 nm and equal to or smaller than the wavelength of i-ray), i-ray, h-ray, and g-ray by about 100 degrees or more and about 300 degrees or less.

The lower layer LL may include a metal material. According to an embodiment, the lower layer LL may include molybdenum (Mo) and silicon (Si). In an embodiment, for example, the lower layer LL may include oxides, nitrides, or oxynitrides containing molybdenum and silicon. According to an embodiment, the lower layer LL may include chromium (Cr). In an embodiment, for example, the lower layer LL may include oxides, nitrides, or oxynitrides containing chromium. However, the material for the lower layer LL should not be limited thereto or thereby as long as the material may control the light transmittance and the phase of the light.

The upper layer UL may be disposed on the lower layer LL. The upper layer UL may block the exposure light. The upper layer UL may include a light blocking material. The upper layer UL may be referred to as a light blocking layer.

According to an embodiment, the main pattern may correspond to an area where the base substrate BS is exposed through an opening (hereinafter, referred to as a main opening) defined through the lower layer LL and the upper layer UL. Accordingly, the light passing through and exiting from the main pattern may be transferred to the resist layer during the exposure process.

The auxiliary pattern may correspond to an area where the lower layer LL is exposed through an opening (hereinafter, referred to as an auxiliary opening) defined through the upper layer UL. Accordingly, during the exposure process, the phase of the light passing through the auxiliary pattern may be changed and may cause a destructive interference with the light passing through the main pattern, and as a result, an intensity of the light passing through the main pattern may be increased. In such an embodiment, a maximum light intensity of the light passing through the main pattern may be increased, and a minimum light intensity of the light passing through the main pattern may be decreased, so that a contrast ratio may be increased. Accordingly, the precision and reliability of the exposure process using the photomask PM may be improved.

FIG. 1C shows patterns of the photomask PM as a representative example. Referring to FIG. 1C, an embodiment of the photomask PM may include a first light-transmitting portion TP1, a second light-transmitting portion TP2, and a light shielding portion SP.

The first light-transmitting portion TP1 may include main patterns M1, M2, M3, and M4, also termed as group main patterns. The shape and position of the first light-transmitting portion TP1 may correspond to the shape and position of the patterns to be formed in the display panel DP (refer to FIG. 2A).

The second light-transmitting portion TP2 may include auxiliary patterns A1, A2, A3, and A4, also termed as group auxiliary patterns. The second light-transmitting portion TP2 may have a light transmittance lower than that of the first light-transmitting portion TP1 and may change the phase of the light passing therethrough.

The light shielding portion SP may correspond to a portion except the first light-transmitting portion TP1 and the second light-transmitting portion TP2 and may surround the first light-transmitting portion TP1 and the second light-transmitting portion TP2. That is, the light shielding portion SP may be the portion except the main patterns M1, M2, M3, and M4 and the auxiliary patterns A1, A2, A3, and A4, and the light may not transmit the light shielding portion SP.

The photomask PM may include a first group pattern G1, a second group pattern G2, a third group pattern G3, and a fourth group pattern G4. Each of the first, second, third, and fourth group patterns G1, G2, G3, and G4 may include the first and second light-transmitting portions TP1 and TP2.

The first light-transmitting portion TP1 of the first group pattern G1 may include a first group main pattern M1 including one (or a single) main pattern, and the second light-transmitting portion TP2 of the first group pattern G1 may include a first group auxiliary pattern A1 surrounding the one first group main pattern M1.

The first light-transmitting portion TP1 of the second group pattern G2 may include a second group main pattern M2 including two main patterns M21 and M22 adjacent to each other. The second light-transmitting portion TP2 of the second group pattern G2 may include a second group auxiliary pattern A2 including a plurality of patterns disposed between the two main patterns M21 and M22 adjacent to each other or respectively surrounding the two main patterns M21 and M22 adjacent to each other.

The first light-transmitting portion TP1 of the third group pattern G3 may include a third group main pattern M3 including three main patterns M31, M32, and M33 adjacent to each other. The second light-transmitting portion TP2 of the third group pattern G3 may include a third group auxiliary pattern A3 including a plurality of patterns disposed between the three main patterns M31, M32, and M33 adjacent to each other or respectively surrounding the three main patterns M31, M32, and M33 adjacent to each other.

The first light-transmitting portion TP1 of the fourth group pattern G4 may include a fourth group main pattern M4 including four main patterns M41, M42, M43, and M44 adjacent to each other. The second light-transmitting portion TP2 of the fourth group pattern G4 may include a fourth group auxiliary pattern A4 including a plurality of patterns disposed between the four main patterns M41, M42, M43, and M44 adjacent to each other or respectively surrounding the four main patterns M41, M42, M43, and M44 adjacent to each other.

Positions of the first, second, third, and fourth group patterns G1, G2, G3, and G4 shown in FIG. 1C are merely example, and the positions of the first, second, third, and fourth group patterns G1, G2, G3, and G4 may be designed in various ways by taking into account the positions of the patterns to be formed in the display panel DP (refer to FIG. 2A). Detailed features of the first, second, third, and fourth group patterns G1, G2, G3, and G4 will be described later.

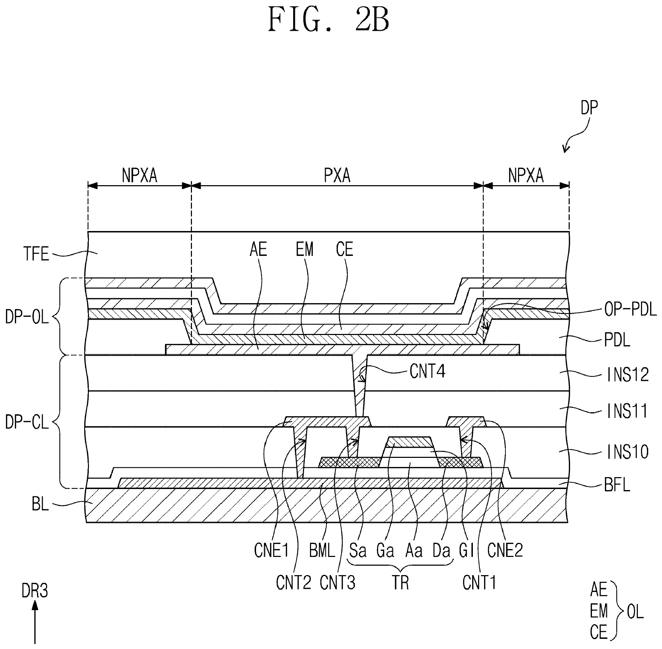

FIG. 2A is a perspective view of the display panel DP according to an embodiment of the invention. FIG. 2B is an enlarged cross-sectional view of a portion of the display panel DP according to an embodiment of the invention.

Referring to FIG. 2A, an embodiment of the display panel DP may be activated in response to electrical signals to generate an image. The display panel DP may include various types of display panel to provide the image to a user. In an embodiment, for example, the display panel DP may be applied to a large-sized electronic item, such as a television set or an outdoor billboard, and a small and medium-sized electronic item, such as a monitor, a mobile phone, a tablet computer, a navigation unit, and a game unit.

The display panel DP may be a light emitting type display panel, however, it should not be particularly limited. In an embodiment, for example, the display panel DP may be an organic light emitting display panel or an inorganic light emitting display panel. A light emitting layer of the organic light emitting display panel may include an organic light emitting material. A light emitting layer of the inorganic light emitting display panel may include a quantum dot, a quantum rod or a micro-light emitting diode (micro-LED). Hereinafter, for convenience of description, embodiments where the display panel DP is an organic light emitting display panel will be described.

The display panel DP may have a rectangular shape with short sides extending in the first direction DR1 and long sides extending in the second direction DR2 in a plane, however, the shape of the display panel DP should not be limited thereto or thereby. According to an embodiment, the display panel DP may have a variety of shapes, such as a circular shape, a polygonal shape, etc.

The display panel DP may include a display area DP-DA and a non-display area DP-NDA. The image may be displayed through the display area DP-DA. Pixels PX may be arranged in the display area DP-DA. Each of the pixels PX may include a pixel driving circuit and a light emitting element electrically connected to the pixel driving circuit.

The non-display area DP-NDA may surround the display area DP-DA and may not display the image, however, it should not be particularly limited. According to an embodiment, the non-display area DP-NDA may be defined adjacent to only a portion of the display area DP-DA or may be omitted.

Referring to FIG. 2B, the display panel DP may include a base layer BL, a circuit layer DP-CL, a display element layer DP-OL, and an encapsulation layer TFE.

The base layer BL may provide a base surface on which the circuit layer DP-CL is disposed. The base layer BL may include a glass substrate, a polymer substrate, or an organic/inorganic composite substrate. The base layer BL may have a single-layer or multi-layer structure.

The circuit layer DP-CL may be disposed on the base layer BL. The circuit layer DP-CL may include at least one insulating layer and a circuit element. The circuit element may include a signal line and the pixel driving circuit. The circuit layer DP-CL may be formed by forming an insulating layer, a semiconductor layer, and a conductive layer using a coating or depositing process and patterning the insulating layer, the semiconductor layer, and the conductive layer using a photolithography process.

The circuit layer DP-CL may include a light blocking pattern BML, a transistor TR, connection electrodes CNE1 and CNE2, an insulating pattern GI, and first, second and third insulating layers INS10, INS11, and INS12. The light blocking pattern BML, the transistor TR, and the connection electrodes CNE1 and CNE2 may correspond to conductive patterns, and the insulating pattern GI and the first, second and third insulating layers INS10, INS11, and INS12 may correspond to at least one insulating layer.

The light blocking pattern BML may be disposed on the base layer BL. The light blocking pattern BML may overlap the transistor TR. The light blocking pattern BML may include a metal material.

The circuit layer DP-CL may further include a buffer layer BFL disposed on the base layer BL. The buffer layer BFL may cover the light blocking pattern BML. The buffer layer BFL may increase a coupling force between the base layer BL and the semiconductor pattern. The buffer layer BFL may include an inorganic material.

The semiconductor pattern of the transistor TR may be disposed on the buffer layer BFL. The semiconductor pattern may have different electrical properties depending on whether it is doped or not or whether it is doped with an N-type dopant or a P-type dopant. The semiconductor pattern may include a first region having a relatively high conductivity and a second region having a relatively low conductivity. The first region may be doped with an N-type dopant or a P-type dopant. A P-type transistor may include a doped region doped with the P-type dopant, and an N-type transistor may include a doped region doped with the N-type dopant. The second region may be a non-doped region or a region doped at a concentration lower than that of the first region. The semiconductor pattern of the transistor TR may include a source area Sa, a drain area Da, and a channel area Aa.

The insulating pattern GI may be disposed on the semiconductor pattern of the transistor TR. The insulating pattern GI may be formed by forming an insulating layer on the semiconductor pattern of the transistor TR and patterning the insulating layer. A gate electrode Ga may be disposed on the insulating pattern GI. The gate electrode Ga may overlap the channel area Aa.

The first, second and third insulating layers INS10, INS11, and INS12 may be disposed on the buffer layer BFL. Each of the first, second and third insulating layers INS 10, INS11, and INS12 may include at least one inorganic layer or an organic layer. The first insulating layer INS10 may be disposed on the buffer layer BFL and may cover the gate electrode Ga and the insulating pattern GI.

The connection electrodes CNE1 and CNE2 may include first and second connection electrodes CNE1 and CNE2 disposed on the first insulating layer INS10. The first connection electrode CNE1 may be connected to the source area Sa of the transistor TR via a third contact hole CNT3 defined through the first insulating layer INS10 . According to an embodiment, the first connection electrode CNE1 may be connected to the light blocking pattern BML via a second contact hole CNT2 defined through the first insulating layer INS10 and the buffer layer BFL.

The second connection electrode CNE2 may be connected to the drain area Da of the transistor TR via a first contact hole CNT1 defined through the first insulating layer INS10. The second connection electrode CNE2 may extend to be connected to another transistor or wire when viewed in a plane view (e.g., a top plan view) or when viewed in the third direction DR3.

The second and third insulating layers INS11 and INS12 may be disposed on the first insulating layer INS10 to cover the connection electrodes CNE1 and CNE2. The second and third insulating layers INS 11 and INS12 may be provided with a fourth contact hole CNT4 defined therethrough to expose a portion of the first connection electrode CNE1, and the first connection electrode CNE1 may be connected to a first electrode AE of the light emitting element OL disposed on the third insulating layer INS12 via a fourth contact hole CNT4. According to an embodiment, the third insulating layer INS12 may include an organic layer and may provide a flat upper surface thereon.

The photomask PM (refer to FIG. 1A) may be used for a process of patterning the insulating layers INS10, INS11, and INS12 to allow the contact holes CNT1, CNT2, CNT3, and CNT4 to be formed through the insulating layers INS10, INS11, and INS12 in the display panel DP. That is, as the portion of the conductive pattern covered by the insulating layer is exposed, a path through which the conductive pattern is electrically connected to a conductive pattern disposed on another layer may be provided.

In such an embodiment, as a resolution of the display panel DP increases, a separation distance between the contact holes, e.g., the first, second and third contact holes CNT1, CNT2, and CNT3, may also decrease. According to embodiments of the invention, as the exposure precision and the exposure reliability of the photomask PM (refer to FIG. 1A) are improved, contact holes with improved reliability may be provided in forming high-resolution contact holes.

The display element layer DP-OL may be disposed on the circuit layer DP-CL. The display element layer DP-OL may include the light emitting element OL and a pixel definition layer PDL. The light emitting element OL may be connected to the transistor TR of the circuit layer DP-CL and may emit a light in the display area DP-DA (refer to FIG. 2A).

According to an embodiment, the light emitting element OL may include an organic light emitting element, an inorganic light emitting element, a quantum dot light emitting element, a micro-LED light emitting element, or a nano-LED light emitting element, however, it should not be limited there to or thereby. According to an embodiment, the light emitting element OL may include various embodiments as long as a light is generated or an amount of light is controlled according to electrical signals.

The light emitting element OL may include the first electrode AE, a light emitting portion EM, and a second electrode CE, which are sequentially stacked one on another. The first electrode AE may be disposed on the third insulating layer INS 12.

The pixel definition layer PDL may be disposed on the third insulating layer INS 12 and the first electrode AE. The pixel definition layer PDL may be provided with a light emitting opening OP-PDL defined therethrough. At least a portion of the first electrode AE may be exposed through the light emitting opening OP-PDL. In an embodiment, a light emitting area PXA may correspond to a size of the light emitting opening OP-PDL. The area in which the pixel definition layer PDL is disposed may correspond to a non-light-emitting area NPXA. An area of the first electrode AE of the light emitting element OL, which is exposed without being covered by the pixel definition layer PDL, may be defined as the light emitting area PXA.

The light emitting portion EM may be disposed on the first electrode AE and the pixel definition layer PDL. The light emitting portion EM may include a light emitting layer and a functional layer to control an electron and a hole. The light emitting portion EM may include an organic light emitting material, an inorganic light emitting material, a quantum dot, or a quantum rod.

The second electrode CE may be disposed on the light emitting portion EM. A common voltage may be applied to the second electrode CE.

The encapsulation layer TFE may be disposed on the display element layer DP-OL and may encapsulate the light emitting element OL. The encapsulation layer TFE may have a multi-layer structure in which an inorganic layer and an organic layer are repeatedly stacked. In an embodiment, for example, the encapsulation layer TFE may have a structure of an inorganic layer/an organic layer/an inorganic layer. The inorganic layers may protect the light emitting element OL from external moisture, and the organic layer may prevent the light emitting element OL from getting scratches due to foreign substances introduced during the manufacturing process.

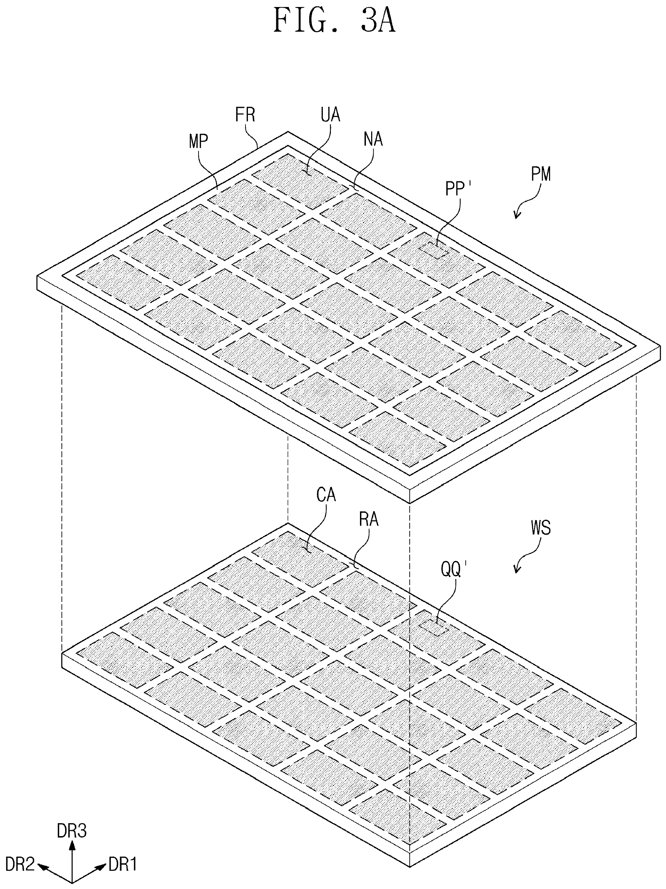

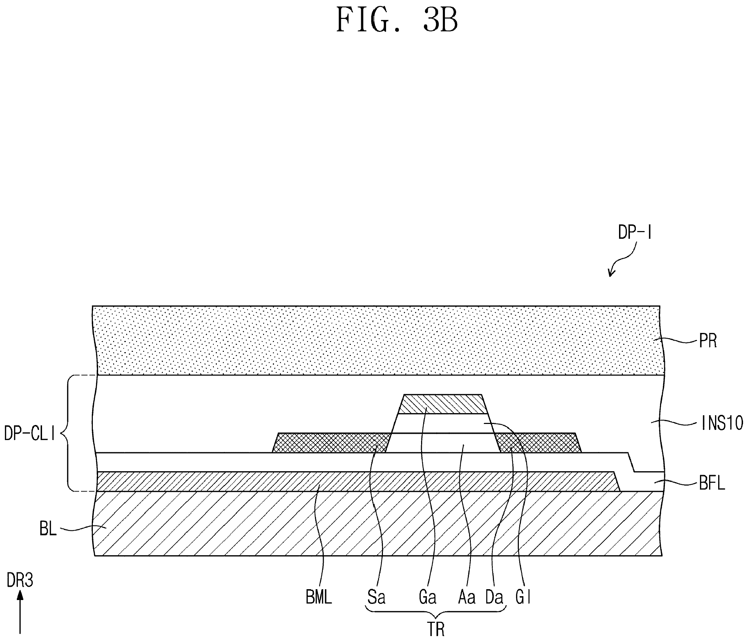

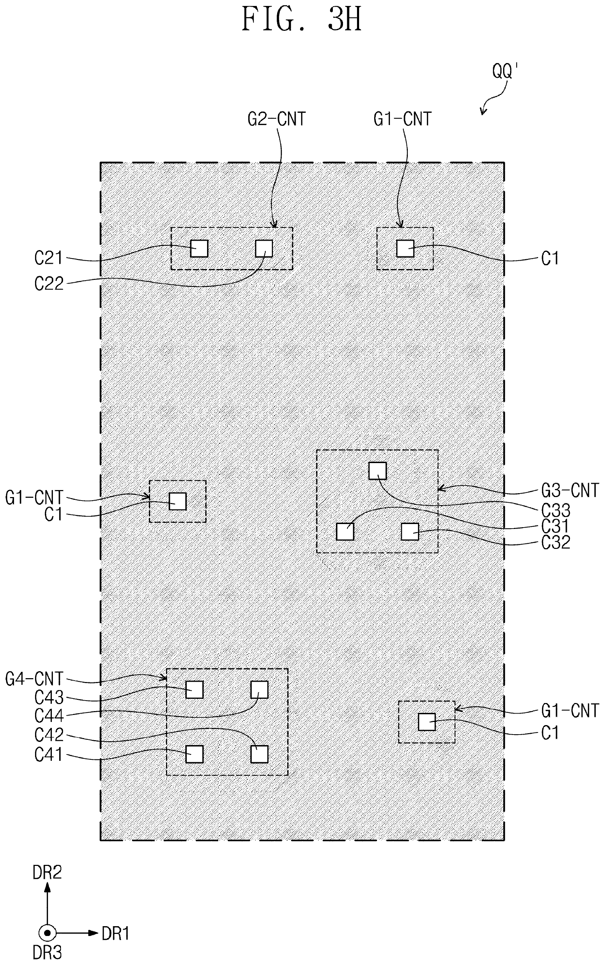

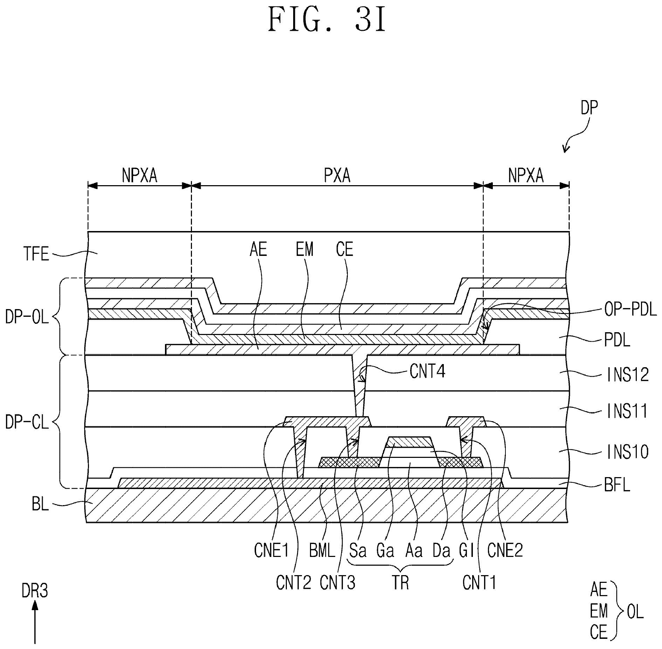

FIG. 3A is a perspective view of a process of a method of manufacturing the display panel according to an embodiment of the invention. FIGS. 3B to 3G and 3I are cross-sectional views of processes of a method of manufacturing the display panel according to an embodiment of the invention. FIG. 3H is an enlarged plan view of a process of a method of manufacturing the display panel according to an embodiment of the invention.

Referring to FIG. 3A, a work substrate WS may be used in the manufacturing method of the display panel. For the convenience of illustration and description, FIG. 3A shows the work substrate WS and the photomask PM disposed above the work substrate WS.

The work substrate WS may include a plurality of cell areas CA and a remaining area RA surrounding the cell areas CA. The cell areas CA may be arranged in the first direction DR1 and the second direction DR2.

One display panel DP (refer to FIG. 2A) may be formed by commonly performing deposition and coating processes over the cell areas CA and then by cutting each of the cell areas CA. That is, each of the cell areas CA of the work substrate WS may correspond to one preliminary display panel DP-I (refer to FIG. 3B). Accordingly, each of the cell areas CA may have a shape corresponding to the shape of the display panel DP (refer to FIG. 2A) to be manufactured. In an embodiment, for example, each of the cell areas CA may have a quadrangular shape.

The cell areas CA may be arranged to correspond to the arrangement of the unit areas UA of the photomask PM. During the exposure process, the photomask PM may be disposed above the work substrate WS in a way such that the cell areas CA may correspond to the unit areas UA, respectively.

Hereinafter, an embodiment of the manufacturing method of the display panel will be described with reference to FIGS. 3B to 3H. FIGS. 3B to 3H which are enlarged views of one preliminary display panel DP-I corresponding to one cell area CA of the work substrate WS of FIG. 3A, and hereinafter, the manufacturing method of the display panel will be described with respect to the one preliminary display panel DP-I.

Referring to FIG. 3B, the preliminary display panel DP-I may include the base layer BL and a preliminary circuit layer DP-CLI. The preliminary circuit layer DP-CLI may include a conductive pattern and at least one insulating layer.

The preliminary circuit layer DP-CLI may include the light blocking pattern BML disposed on the base layer BL, the buffer layer BFL disposed on the base layer BL and covering the light blocking pattern BML, the semiconductor pattern disposed on the buffer layer BFL, the insulating pattern GI disposed on the semiconductor pattern, the gate electrode Ga disposed on the insulating pattern GI, and the first insulating layer INS 10 disposed on the buffer layer BFL and covering the semiconductor pattern and the gate electrode Ga.

According to an embodiment, the light blocking pattern BML, the semiconductor pattern, and the gate electrode Ga may correspond to the conductive pattern, and the buffer layer BFL, the insulating pattern GI, and the first insulating layer INS 10 may correspond to the at least one insulating layer.

The preliminary display panel DP-I may include a resist layer PR disposed on an uppermost insulating layer of the at least one insulating layer. The resist layer PR may be provided by a coating process. The resist layer PR may include a negative-type photosensitive material, and portions of the resist layer PR, which are exposed to a light, may be removed, however, it should not be limited thereto or thereby. According to an embodiment, the resist layer PR may include a positive-type photosensitive material.

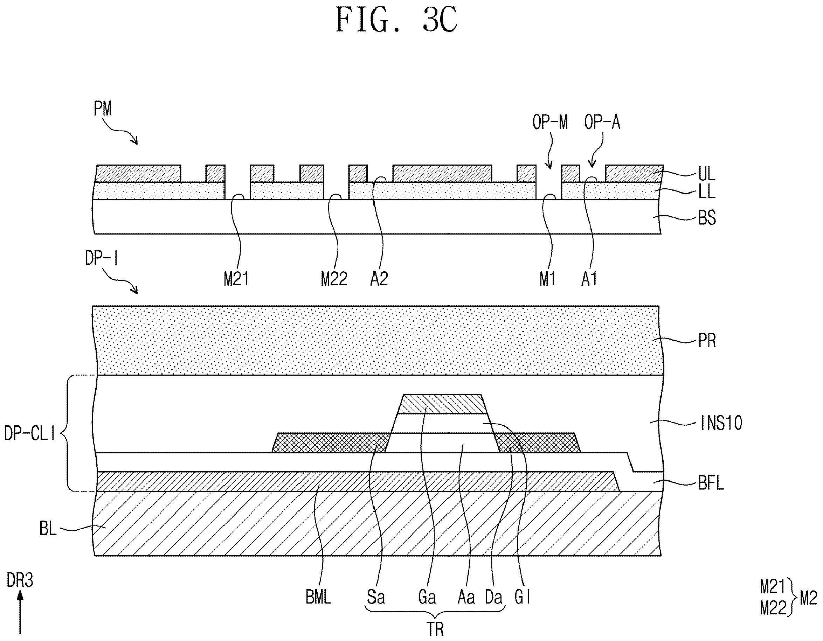

Referring to FIG. 3C, the manufacturing method of the display device may include placing the photomask PM above the preliminary display panel DP-I.

The photomask PM may include the base substrate BS, the lower layer LL, and the upper layer UL. FIG. 3C is a cross-sectional view of one first group pattern G1 and one second group pattern G2, and the photomask PM may include one main pattern of the first group main pattern M1, the first group auxiliary pattern A1 surrounding the one main pattern of the first group main pattern M1, two main patterns M21 and M22 adjacent to each other of the second group main pattern M2 and the second group auxiliary pattern A2 disposed between the two main patterns M21 and M22 or surrounding each of the two main patterns M21 and M22.

As shown in FIG. 3C, the first and second group main patterns M1 and M2 may be defined by main openings OP-M defined through the lower layer LL and the upper layer UL, and the first and second group auxiliary patterns A1 and A2 may be defined by auxiliary openings OP-A defined through only the upper layer UL. An arrangement relationship of the main openings OP-M and the auxiliary openings OP-A will be described in detail later.

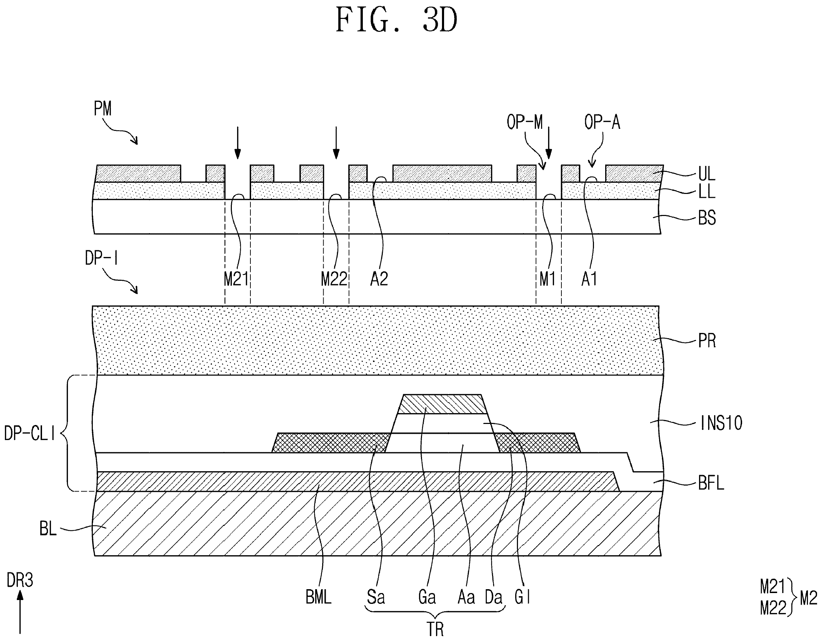

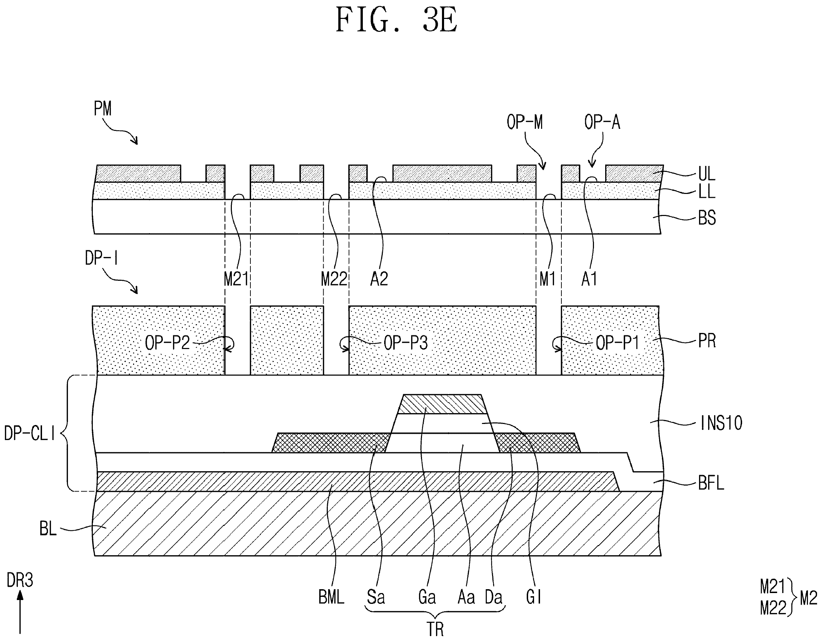

Referring to FIGS. 3D and 3E, the manufacturing method of the display device may include patterning the resist layer PR. The patterning of the resist layer PR may include radiating light to portions of the resist layer PR through the photomask PM (hereinafter, referred to as the exposure process) and removing the portions of the resist layer PR to which the light is radiated (hereinafter, referred to as the development process).

As shown in FIG. 3D, most of the light passing through the main openings OP-M defined through the lower layer LL and the upper layer UL among the light radiated to the photomask PM may reach the resist layer PR during the exposure process. According to an embodiment of the invention, even though the separation distance between the main openings OP-M decreases, the exposure precision may be improved by designing the shape and arrangement of the auxiliary openings OP-A to prevent an occurrence of an optical interaction between the auxiliary openings OP-A surrounding the main openings OP-M. This will be described in detail later.

Then, as shown in FIG. 3E, when the portions of the resist layer PR to which the light is radiated are removed by using a development solution in the development process, exposure openings OP-P1, OP-P2, and OP-P3 (or the exposure patterns) may be formed in the resist layer PR. In an embodiment, for example, the exposure openings OP-P1, OP-P2, and OP-P3 may include a first exposure opening OP-P1 corresponding to the one main pattern of the first group main pattern M1 and second and third exposure openings OP-P2 and OP-P3 respectively corresponding to the two main patterns M21 and M22 adjacent to each other of the second group main pattern M2. The exposure openings OP-P1, OP-P2, and OP-P3 (or the exposure patterns) may correspond to the main openings OP-M (or the main patterns M1 and M2). A portion of the first insulating layer INS10 may be exposed through the exposure openings OP-P1, OP-P2, and OP-P3.

According to an embodiment of the invention, as the photomask PM improves the exposure precision, the reliability and precision in the patterning process of the resist layer PR may be improved.

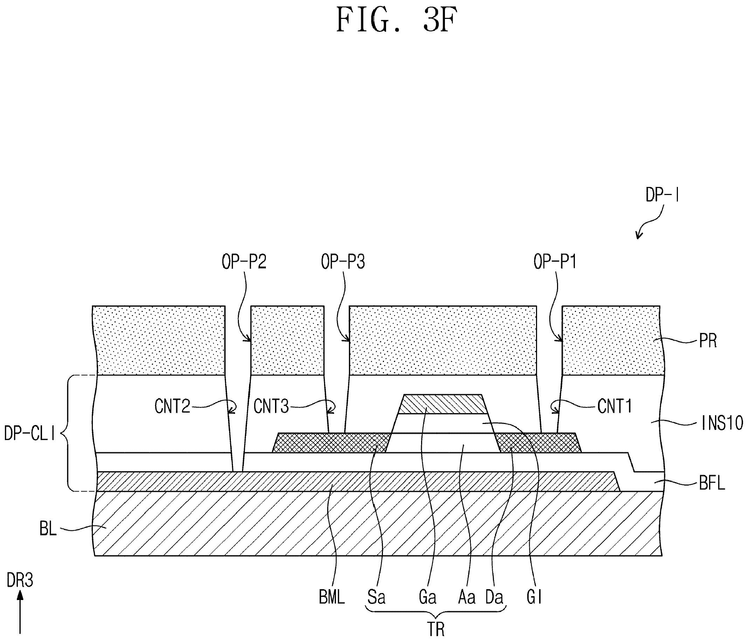

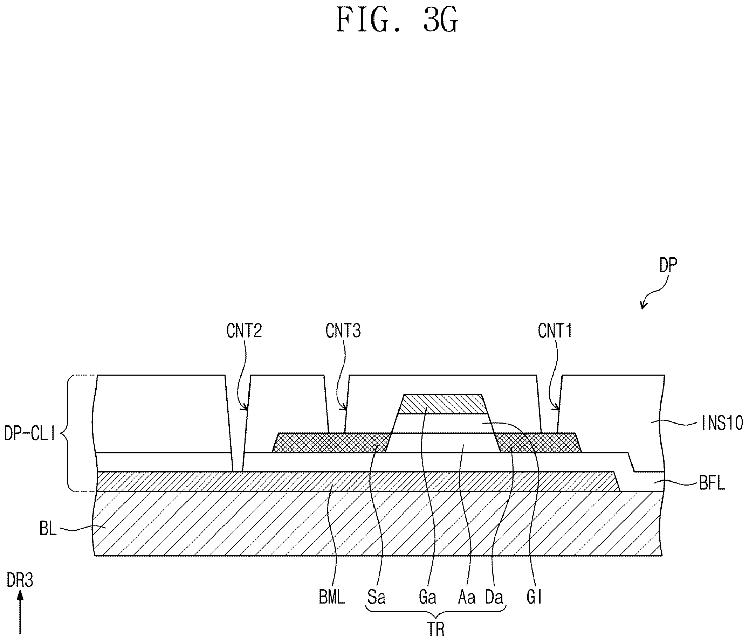

Referring to FIGS. 3F and 3G, the manufacturing method of the display device may include forming the contact holes CNT1, CNT2, and CNT3 through the uppermost insulating layer, e.g., the first insulating layer INS 10. According to an embodiment of the embodiment, the forming of the contact holes CNT1, CNT2, and CNT3 through the first insulating layer INS10 may include etching the first insulating layer INS10 using the patterned resist layer PR (hereinafter, referred to as the etching process) and removing the patterned resist layer PR.

As shown in FIG. 3F, portions of the first insulating layer INS10, which are exposed through the exposure openings OP-P1, OP-P2, and OP-P3 without being covered by the resist layer PR, may be removed through the etching process. In such an embodiment, the patterned resist layer PR may serve as a mask in the etching process of the first insulating layer INS10.

In an embodiment, for example, the first, second and third contact holes CNT1, CNT2, and CNT3 may be formed to respectively correspond to the first, second, and third exposure openings OP-P1, OP-P2, and OP-P3. The first contact hole CNT1 may be formed through the first insulating layer INS10. The drain area Da of the semiconductor pattern may be exposed via the first contact hole CNT1 defined through the first insulating layer INS10. The second contact hole CNT2 may be formed through the first insulating layer INS10 and the buffer layer BFL. The light blocking pattern BML may be exposed via the second contact hole CNT2 defined through the first insulating layer INS10 and the buffer layer BFL. The third contact hole CNT3 may be formed through the first insulating layer INS10. The source area Sa of the semiconductor pattern may be exposed via the third contact hole CNT3 defined through the first insulating layer INS10.

FIG. 3F shows an embodiment having a structure in which the first contact hole CNT1 is formed from the first exposure opening OP-P1 formed using the first group main pattern M1 (refer to FIG. 3E) and the second and third contact holes CNT2 and CNT3 are formed from the second and third exposure openings OP-P2 and OP-P3 formed using the two main patterns M21 and M22 (refer to FIG. 3E) adjacent to each other of the second group main pattern M2 (refer to FIG. 3E) as a representative example, however, the invention should not be limited thereto or thereby. The types of the main patterns M1, M2, M3, and M4 (refer to FIG. 1C) to use may vary depending on the arrangement relationship and/or separation distance of the contact holes.

Then, as shown in FIG. 3G, when the contact holes CNT1, CNT2, and CNT3 are formed through the first insulating layer INS 10 and the resist layer PR is removed, it may be regarded that a process of using the photomask PM to manufacture the display panel DP is completed.

According to an embodiment of the invention, with the improvement in the reliability and precision of the patterning process of the resist layer PR, the reliability and precision of the patterning process of the insulating layer may be improved in the manufacturing of the high-resolution display panel DP (refer to FIG. 2A).

FIG. 3H shows the display panel DP (refer to FIG. 3G) corresponding to an area QQ' of FIG. 3A, and contact holes formed using the photomask PM corresponding to an area PP' of FIG. 3A are shown.

Referring to FIGS. 1C, 3A, and 3H, a first group contact hole G1-CNT including one contact hole C1 corresponding to one main pattern of the first group main pattern M1 of the photomask PM may be formed. A second group contact hole G2-CNT including two contact holes C21 and C22 adjacent to each other and respectively corresponding to the two main patterns M21 and M22 adjacent to each other of the second group main pattern M2 of the photomask PM may be formed. The first contact hole CNT1 of FIG. 3F may correspond to the first group contact hole G1-CNT, and the second and third contact holes CNT2 and CNT3 of FIG. 3F may correspond to the second group contact hole G2-CNT.

A third group contact hole G3-CNT including three contact holes C31, C32, and C33 adjacent to each other and respectively corresponding to the three main patterns M31, M32, and M33 adjacent to each other of the third group main pattern M3 of the photomask PM may be formed. A fourth group contact hole G4-CNT including four contact holes C41, C42, C43, and C44 adjacent to each other and respectively corresponding to the four main patterns M41, M42, M43, and M44 adjacent to each other of the fourth group main pattern M4 of the photomask PM may be formed.

According to an embodiment of the invention, even though the separation distance between the contact holes C21, C22, C31, C32, C33, C41, C42, C43, and C44 to be formed in the second, third, and fourth group contact holes G2-CNT, G3-CNT, and G4-CNT decreases, contact holes may be effectively prevented from being defective or from being generated outside of a preset area in the manufacturing process, and thus, the process reliability and the process efficiency of the method of manufacturing the display panel may be improved.

Referring to FIG. 3I, the manufacturing method of the display device may further include forming additional conductive patterns and additional insulating layers on the first insulating layer INS10 . Accordingly, the display panel DP including the base layer BL, the circuit layer DP-CL, the display element layer DP-OL, and the encapsulation layer TFE may be formed.

The additional conductive patterns and the additional insulating layers that are selectively patterned may be further formed through multiple times of coating, deposition, and photolithography processes. In an embodiment, for example, the additional conductive patterns may correspond to the first and second connection electrodes CNE1 and CNE2 and the first electrode AE, and the additional insulating layers may correspond to the second and third insulating layers INS 11 and INS 12 and the pixel definition layer PDL. In addition, the light emitting portion EM, the second electrode CE, and the encapsulation layer TFE may be further formed through a deposition process.

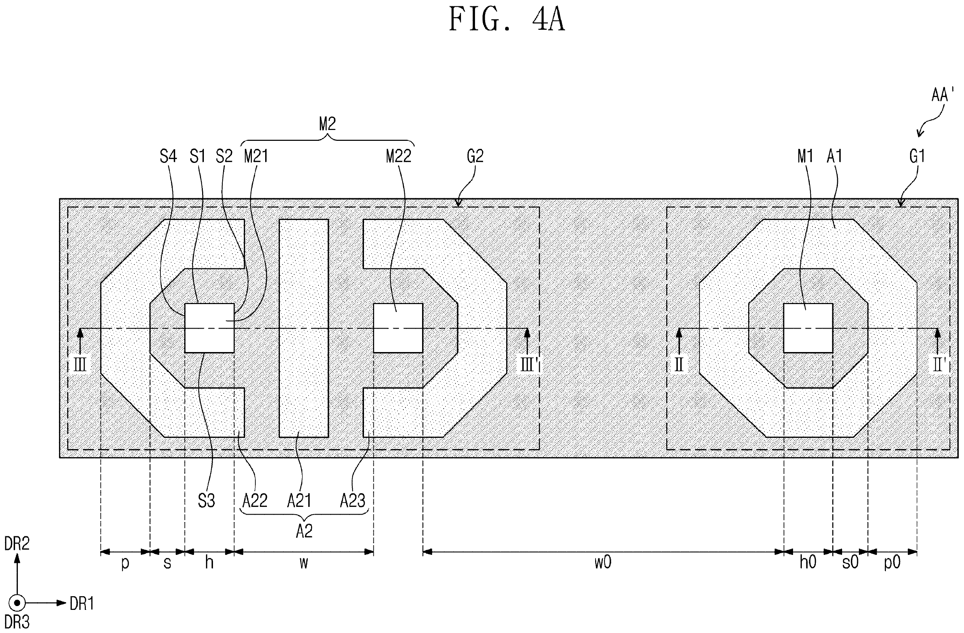

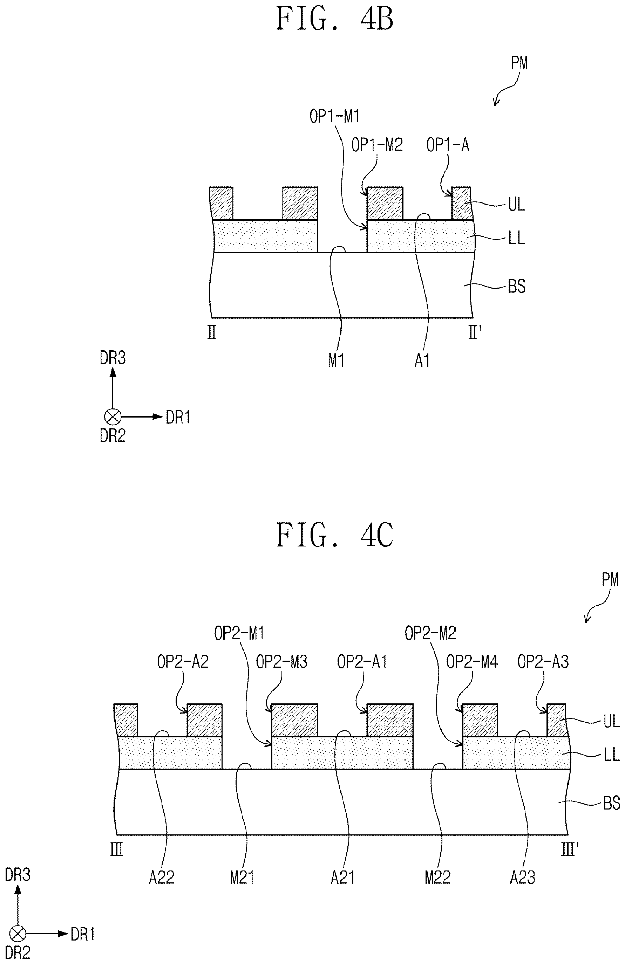

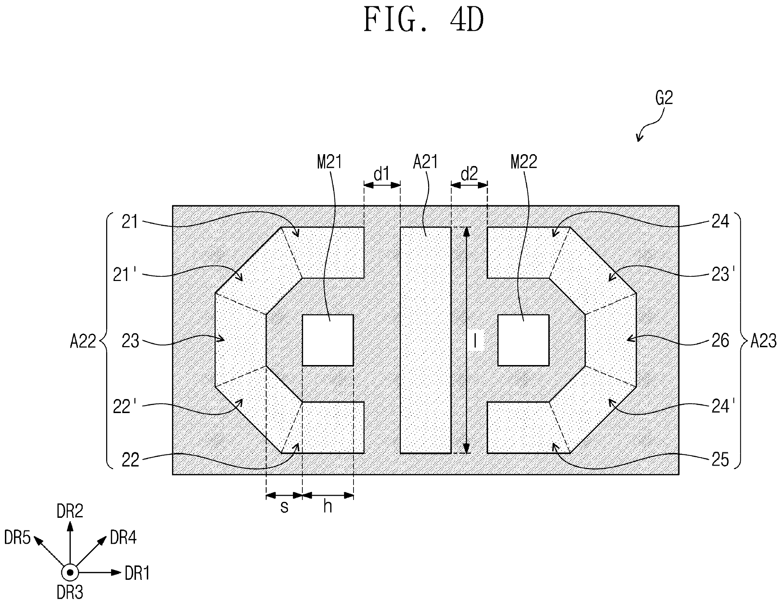

FIG. 4A is an enlarged plan view of a portion of the photomask in an area AA' of FIG. 1C according to an embodiment of the invention. FIG. 4B is a cross-sectional view of the photomask taken along line II-II' of FIG. 4A according to an embodiment of the invention. FIG. 4C is a cross-sectional view of the photomask taken along line III-III' of FIG. 4A according to an embodiment of the invention. FIG. 4D is an enlarged plan view of a portion of the photomask according to an embodiment of the invention. FIG. 4A shows one first group pattern G1 and one second group pattern G2.

Referring to FIGS. 4A and 4B, the first group pattern G1 may include the first group main pattern M1 including one main pattern and the first group auxiliary pattern A1 including one auxiliary pattern. Hereinafter, the one main pattern of the first group main pattern M1 will be assigned with the same reference numeral as the first group main pattern M1, and the one auxiliary pattern of the first group auxiliary pattern A1 will be assigned with the same reference numeral as the first group auxiliary pattern A1.

The main pattern M1 may have a quadrangular shape. According to an embodiment, the main pattern M1 may have a square shape, however, it should not be particularly limited. According to an embodiment, the main pattern M1 may have a polygonal shape, such as a rectangular shape, a lozenge shape, and an octagonal shape, or a circular shape.

The auxiliary pattern A1 may entirely surround the main pattern M1. The auxiliary pattern A1 may have a closed-line shape in a plan view. According to an embodiment, the closed-line shape of the auxiliary pattern A1 may be an octagonal shape.

As shown in FIG. 4B, a first main opening OP1-M1 may be defined through the lower layer LL. A second main opening OP1-M2 corresponding to the first main opening OP1-M1 and an auxiliary opening OP1-A surrounding the second main opening OP1-M2 may be defined through the upper layer UL. An area of the base substrate BS exposed through the first and second main openings OP1-M1 and OP1-M2 may correspond to the main pattern M1, and an area of the lower layer LL exposed through the auxiliary opening OP1-A may correspond to the auxiliary pattern A1.

Referring to FIGS. 4A and 4C, the second group pattern G2 may include the second group main pattern M2 including the two main patterns M21 and M22 adjacent to each other and the second group auxiliary pattern A2.

The second group main pattern M2 may include a first main pattern M21 and a second main pattern M22. FIG. 4A shows an embodiment having a structure in which the first and second main patterns M21 and M22 are arranged spaced apart from each other in the first direction DR1.

Each of the first and second main patterns M21 and M22 may have a quadrangular shape. Each of the first and second main patterns M21 and M22 may include first, second, third, and fourth side portions S1, S2, S3, and S4. The first side portion S1 may be spaced apart from a center of each of the first and second main patterns M21 and M22 to the second direction DR2 and may extend in the first direction DR1. The second side portion S2 may be spaced apart from the center to the first direction DR1 and may extend in the second direction DR2. The third side portion S3 may be spaced apart from the center to a direction opposite to the second direction DR2 and may extend in the first direction DR1. The fourth side portion S4 may be spaced apart from the center to a direction opposite to the first direction DR1 and may extend in the second direction DR2. That is, the first, second, third, and fourth side portions S1, S2, S3, and S4 may be sequentially connected to each other in a clockwise direction, and descriptions on the first, second, third, and fourth side portions S1, S2, S3, and S4 of the first main pattern M21 may be applied to side portions of each of the main patterns described hereinafter.

However, the shape of the first and second main patterns M21 and M22 should not be particularly limited, and the first and second main patterns M21 and M22 may have a polygonal shape, such as a rectangular shape, a lozenge shape, an octagonal shape, etc., or a circular shape.

The first and second main patterns M21 and M22 may have substantially a same size as each other. That is, the first and second main patterns M21 and M22 may have substantially a same maximum width h with respect to one direction of the first direction DR1 or the second direction DR2. According to an embodiment, each of the first and second main patterns M21 and M22 may have a square shape having substantially the same width with respect to the first direction DR1 and the second direction DR2.

The second group auxiliary pattern A2 may include a first auxiliary pattern A21, a second auxiliary pattern A22, and a third auxiliary pattern A23.

The first auxiliary pattern A21 may be disposed between the first and second main patterns M21 and M22. The first auxiliary pattern A21 may extend in the second direction DR2. The first auxiliary pattern A21 may have a rectangular shape defined by long sides extending in the second direction DR2 and short sides extending in the first direction DR1.

The second auxiliary pattern A22 may be spaced apart from the first auxiliary pattern A21 with the first main pattern M21 interposed therebetween in the first direction DR1. In an embodiment, the second auxiliary pattern A22 may be spaced apart from the first auxiliary pattern A21 to the direction opposite to the first direction DR1.

The second auxiliary pattern A22 may surround the first main pattern M21. In the disclosure, the expression "an auxiliary pattern surrounds a main pattern" may mean that the auxiliary pattern may at least partially surround the main pattern to face two or more side portions connected to each other among the first, second, third, and fourth side portions S1, S2, S3, and S4 of the main pattern. In an embodiment, the second auxiliary pattern A22 may face the first, third, and fourth side portions S1, S3, and S4 of the first main pattern M21.

The third auxiliary pattern A23 may be spaced apart from the first auxiliary pattern A21 with the second main pattern M22 interposed therebetween in the first direction DR1. In an embodiment, the third auxiliary pattern A23 may be spaced apart from the first auxiliary pattern A21 to the first direction DR1.

The third auxiliary pattern A23 may surround the second main pattern M22. In an embodiment, the third auxiliary pattern A23 may face the first to third side portions of the second main pattern M22.

Referring to FIG. 4C, first and second main openings OP2-M1 and OP2-M2 may be defined through the lower layer LL. A third main opening OP2-M3 corresponding to the first main opening OP2-M1, a fourth main opening OP2-M4 corresponding to the second main opening OP2-M2, a first auxiliary opening OP2-A1 defined between the third and fourth main openings OP2-M3 and OP2-M4, a second auxiliary opening OP2-A2 surrounding the third main opening OP2-M3, and a third auxiliary opening OP2-A3 surrounding the fourth main opening OP2-M4 may be defined through the upper layer UL.

An area of the base substrate BS exposed through the first and third main openings OP2-M1 and OP2-M3 may correspond to the first main pattern M21, and an area of the base substrate BS exposed through the second and fourth main openings OP2-M2 and OP2-M4 may correspond to the second main pattern M22. Areas of the lower layer LL exposed through the first, second and third auxiliary openings OP2-A1, OP2-A2, and OP2-A3 may respectively correspond to the first, second and third auxiliary patterns A21, A22, and A23.

Referring to FIGS. 4A to 4C, a minimum separation distance w0 between the first and second group main patterns M1 and M2, e.g., a separation distance between the main pattern M1 of the first group main pattern M1 and the second main pattern M22 of the second group main pattern M2 may satisfy the following Equation 1.

【Equation 1】

$$w0 > h0 + 2(s0 + p0)$$

In Equation 1, h0 denotes a maximum width of the main pattern M1 (or the second main opening OP1-M2) with respect to one direction of the first and second directions DR1 and DR2. In Equation 1, s0 denotes the separation distance in the first direction DR1 between the main pattern M1 and the auxiliary pattern A1 (or between the second main opening OP1-M2 and the auxiliary opening OP1-A). In Equation 1, p0 denotes a minimum width in the first direction DR1 of the auxiliary pattern A1 (or the auxiliary opening OP1-A).

When the separation distance w0 between the main patterns is greater than h0+2(s0+p0), an optical interaction between the auxiliary patterns, which respectively surround the main patterns, with respect to the exposure light may not occur. That is, although the photomask PM includes the auxiliary pattern A1 having a band shape and entirely surrounding the main pattern M1, the reliability and precision of the exposure patterns formed in the resist layer and the contact holes defined through the insulating layer may not be degraded since there is no other auxiliary pattern exiting within a distance that may have an optical influence on the auxiliary pattern A1.

According to an embodiment, s0 may be equal to or greater than about 0.3 micrometers and equal to or smaller than about 2.5 micrometers. According to an embodiment, p0 may be equal to or greater than about 0.3 micrometers and equal to or smaller than about 2.5 micrometers. According to an embodiment, h0 may be equal to or greater than about 1.0 micrometer and equal to or smaller than about 2.5 micrometers. In such an embodiment, w0 may be greater than about 12.5 micrometers. That is, when one main pattern is spaced apart from the nearest other main pattern by more than about 12.5 micrometers, the shape of the first group auxiliary pattern A1 may be applied as the shape of the auxiliary pattern for the one main pattern.

In an embodiment, a separation distance w between the first and second main patterns M21 and M22 of the second group main pattern M2 (or between the third and fourth main openings OP2-M3 and OP2-M4) may satisfy the following Equation 2.

【Equation 2】

$$2s \leq w \leq h + 2(s+p)$$

In Equation 2, h denotes a maximum width in one direction of the first and second directions DR1 and DR2 of the first main pattern M21 (or the third main opening OP2-M3). In Equation 2, s denotes a separation distance in the first direction DR1 between the first main pattern M21 and the second auxiliary pattern A22 (or between the third main opening OP2-M3 and the second auxiliary opening OP2-A2). In Equation 2, p denotes a minimum width in the first direction DR1 of the second auxiliary pattern A22 (or the second auxiliary opening OP2-A2).

In a case where the separation distance w between the main patterns is equal to or smaller than h+2(s+p), the photomask includes one auxiliary pattern that entirely surrounds one main pattern and the other auxiliary pattern that entirely surrounds the other main pattern as the first group auxiliary pattern A1. In this case, the one auxiliary pattern and the other auxiliary pattern are close to each other, and thus, the interaction occurs with respect to the exposure light. That is, the auxiliary patterns that are close to each other have the optical influence on each other, and the light passing through the auxiliary patterns that are close to each other causes a side lobe phenomenon that causes loss of the resist layer. Accordingly, the exposure pattern is further formed in a position different from the position of the exposure pattern to be formed, so that the contact hole is formed in a position different from the position of the contact hole to be formed. That is, the reliability and precision of the patterning process of the resist layer and the patterning process of the insulating layer may be lowered.

According to an embodiment, the separation distance w between the two main patterns adjacent to each other in the second group pattern G2 is equal to or smaller than h+2(s+p), as described above. As the photomask PM includes the second auxiliary pattern A22 surrounding some portions of the side portions of the first main pattern M21, the third auxiliary pattern A23 surrounding some portions of the side portions of the second main pattern M22, and one first auxiliary pattern A21 disposed between the first and second main patterns M21 and M22 and spaced apart from the second and third auxiliary patterns A22 and A23, the auxiliary patterns adjacent to each other may not have the optical influence on each other even though the first and second main patterns M21 and M22 are arranged adjacent to each other. Accordingly, the light passing through the auxiliary patterns may not cause the side lobe phenomenon, and high-resolution contact holes may be formed precisely.

In a case, where the separation distance w between the two main patterns is smaller than 2s, a space to place the first auxiliary pattern A21 may not be sufficiently provided between the first and second main patterns M21 and M22. Accordingly, in an embodiment, the second group pattern G2 may be appropriate to apply when the separation distance w between the two main patterns adjacent to each other is equal to or greater than 2s and equal to or smaller than h+2(s+p).

According to an embodiment, s may be equal to or greater than about 0.3 micrometers and equal to or smaller than about 2.5 micrometers. According to an embodiment, p may be equal to or greater than about 0.3 micrometers and equal to or smaller than about 2.5 micrometers. According to an embodiment, h may be equal to or greater than about 1.0 micrometer and equal to or smaller than about 2.5 micrometers. In such an embodiment, w may be equal to or greater than about 0.6 micrometers and equal to or smaller than about 12.5 micrometers. That is, when the distance between the one main pattern and the nearest other main pattern is equal to or greater than about 0.6 micrometers and equal to or smaller than about 12.5 micrometers, the shape of the second group auxiliary pattern A2 may be applied as the shape of the auxiliary pattern for the one main pattern and the other main pattern.

Equation 2 may be similarly applied to the third and fourth group patterns G3 and G4 (refer to FIG. 1C), and thus, in an embodiment, separation distances between the three main patterns M31, M32, and M33 adjacent to each other and separation distances between the four main patterns M41, M42, M43, and M44 adjacent to each other in the third and fourth group patterns G3 and G4 satisfy Equation 2.

Hereinafter, the shape of the first, second and third auxiliary patterns A21, A22, and A23 will be described in detail with reference to FIG. 4D. The first auxiliary pattern A21 may have a quadrangular shape. The first auxiliary pattern A21 may have a rectangular shape defined by long sides extending in the second direction DR2 and short sides extending in the first direction DR1.

In an embodiment, a length l in the second direction DR2 of the first auxiliary pattern A21 (or the first auxiliary opening OP2-A1, refer to FIG. 4C) satisfies the following Equation 3.

【Equation 3】

$$l \geq h + s$$

In a case where the length l in the second direction DR2 of the first auxiliary pattern A21 is smaller than h+s, a deviation between a maximum width of the exposure pattern formed in the resist layer and a predetermined maximum width of the exposure pattern may be large, and the defective contact hole may be formed through the insulating layer due to the resist layer with low-reliability. The reference of the deviation that causes the formation of the defective contact hole may be set to about 10% or less. The reference of the deviation that causes the formation of the defective contact hole may be changed depending on conditions of the photomask PM, such as the size of the first and second main patterns M21 and M22, the separation distance between the first and second main patterns M21 and M22, the separation distance between the first and second main patterns M21 and M22 and the second and third auxiliary patterns A22 and A23, etc., or conditions of the contact hole of the display panel DP (refer to FIG. 2A), such as the size of the contact holes, the separation distance between the contact holes, etc.

In an embodiment, the second auxiliary pattern A22 may include a first sub-pattern 21, a second sub-pattern 22, and a third sub-pattern 23.

Each of the first and second sub-patterns 21 and 22 may extend in the first direction DR1. The first and second sub-patterns 21 and 22 may be spaced apart from each other with the first main pattern M21 interposed therebetween in the second direction DR2. The first sub-pattern 21 may be spaced apart from the first main pattern M21 in the second direction DR2 to face the first side portion S1 (refer to FIG. 4A) of the first main pattern M21, and the second sub-pattern 22 may be spaced apart from the first main pattern M21 in the direction opposite to the second direction DR2 to face the third side portion S3 (refer to FIG. 4A) of the first main pattern M21.

The third sub-pattern 23 may extend in the second direction DR2. The third sub-pattern 23 may be spaced apart from the first main pattern M21 in the direction opposite to the first direction DR1 to face the fourth side portion S4 (refer to FIG. 4A) of the first main pattern M21.

In an embodiment, the second auxiliary pattern A22 may further include a first additional sub-pattern 21' and a second additional sub-pattern 22'.

The first additional sub-pattern 21' may be extend in a fourth direction DR4 corresponding to an oblique direction of (or a direction not perpendicular to) the first direction DR1. The first additional sub-pattern 21' may extend from one end of the third sub-pattern 23 to one end of the first sub-pattern 21. The second additional sub-pattern 22' may extend in a fifth direction DR5 corresponding to a direction crossing the fourth direction DR4. The second additional sub-pattern 22' may extend from another end of the third sub-pattern 23 to one end of the second sub-pattern 22.

According to an embodiment, the third auxiliary pattern A23 may include a fourth sub-pattern 24, a fifth sub-pattern 25, and a sixth sub-pattern 26.

Each of the fourth and fifth sub-patterns 24 and 25 may extend in the first direction DR1. The fourth and fifth sub-patterns 24 and 25 may be spaced apart from each other with the second main pattern M22 interposed therebetween in the second direction DR2. The fourth sub-pattern 24 may be spaced apart from the second main pattern M22 in the second direction DR2 to face the first side portion of the second main pattern M22, and the fifth sub-pattern 25 may be spaced apart from the second main pattern M22 in the direction opposite to the second direction DR2 to face the third side portion of the second main pattern M22.

The sixth sub-pattern 26 may extend in the second direction DR2. The sixth sub-pattern 26 may be spaced apart from the second main pattern M22 in the first direction DR1 to face the second side portion of the second main pattern M22.

In an embodiment, the third auxiliary pattern A23 may further include a third additional sub-pattern 23' and a fourth additional sub-pattern 24'.

The third additional sub-pattern 23' may extend in the fifth direction DR5. The third additional sub-pattern 23' may extend from one end of the sixth sub-pattern 26 to one end of the fourth sub-pattern 24. The fourth additional sub-pattern 24' may extend in the fourth direction DR4. The fourth additional sub-pattern 24' may extend from another end of the sixth sub-pattern 26 to one end of the fifth sub-pattern 25.

In an embodiment, each of a separation distance d1 between the first and second auxiliary patterns A21 and A22 and a separation distance d2 between the first and third auxiliary patterns A21 and A23 satisfies the following Equation 4.

【Equation 4】

$$d1 \geq 0.5s, d2 \geq 0.5s$$

In a case where each of the separation distance d1 between the first and second auxiliary patterns A21 and A22 and the separation distance d2 between the first and third auxiliary patterns A21 and A23 is smaller than about 0.5s or the first and second auxiliary patterns A21 and A22 and/or the first and third auxiliary patterns A21 and A23 are integrally provided, the exposure lights passing through the auxiliary patterns adjacent to each other may be optically influenced by each other, and thus the side lobe phenomenon may occur. Accordingly, in an embodiment, as each of the separation distance d1 between the first and second auxiliary patterns A21 and A22 and the separation distance d2 between the first and third auxiliary patterns A21 and A23 is set to be equal to or greater than about 0.5s, the exposure lights passing through the auxiliary patterns adjacent to each other may not be optically influenced by each other, and the reliability and precision of the patterning process of the resist layer and the patterning process of the insulating layer may be improved.

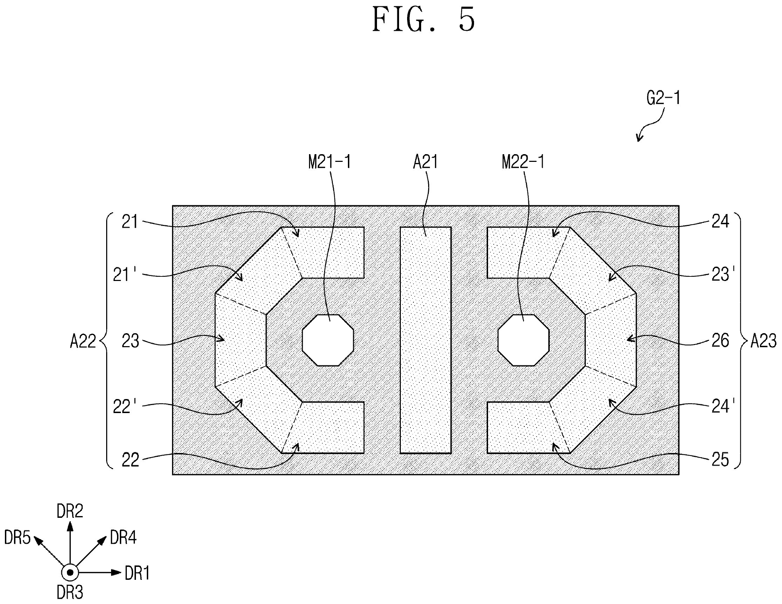

FIG. 5 is an enlarged plan view of a portion of a photomask according to an embodiment of the invention. FIG. 5 is an enlarged plan view of a second group pattern G2-1. In FIG. 5, the same reference numerals denote the same elements in FIGS. 4A and 4D, and thus, any repetitive detailed descriptions of the same elements will be omitted.

Referring to FIG. 5, in an embodiment, each of first and second main patterns M21-1 and M22-1 may have an octagonal shape. Each of the first and second main patterns M21-1 and M22-1 may include two sides extending in the first direction DR1, two sides extending in the second direction DR2, two sides extending in the fourth direction DR4, and two sides extending in the fifth direction DR5. That is, as each of the first and second main patterns M21-1 and M22-1 further includes the sides respectively extending in the fourth and fifth directions DR4 and DR5, first and second additional sub-patterns 21' and 22' of a second auxiliary pattern A22 may respectively face side portions of the first main pattern M21-1, which respectively extend in the fourth and fifth directions DR4 and DR5, and third and fourth additional sub-patterns 23' and 24' of a third auxiliary pattern A23 may respectively face side portions of the second main pattern M22-1, which respectively extend in the fifth and fourth directions DR5 and DR4.

Accordingly, in such an embodiment, a destructive interference of the exposure lights passing through the first and second main patterns M21-1 and M22-1 may occur more uniformly in the side portions of the first main pattern M21-1, which face the first and second additional sub-patterns 21' and 22', and the side portions of the second main pattern M22-1, which face the third and fourth additional sub-patterns 23' and 24'. Thus, the precision and uniformity of the light transferred to the resist layer may be increased.

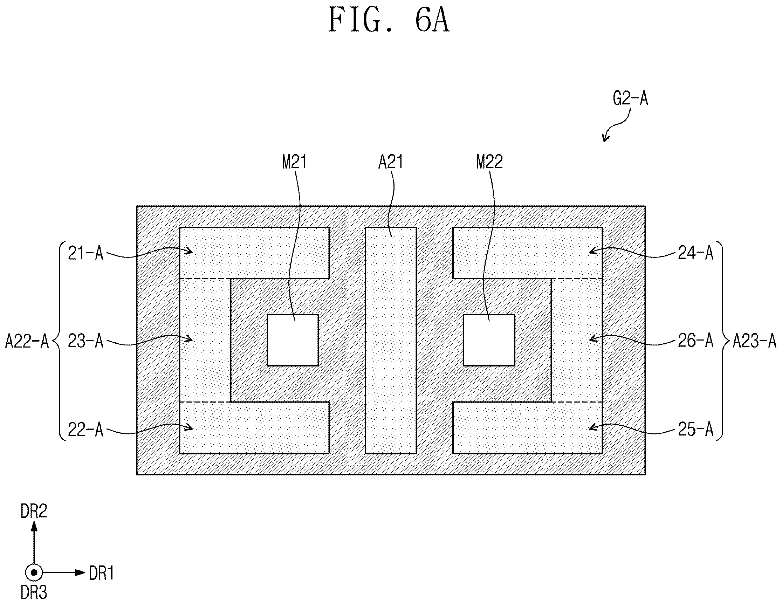

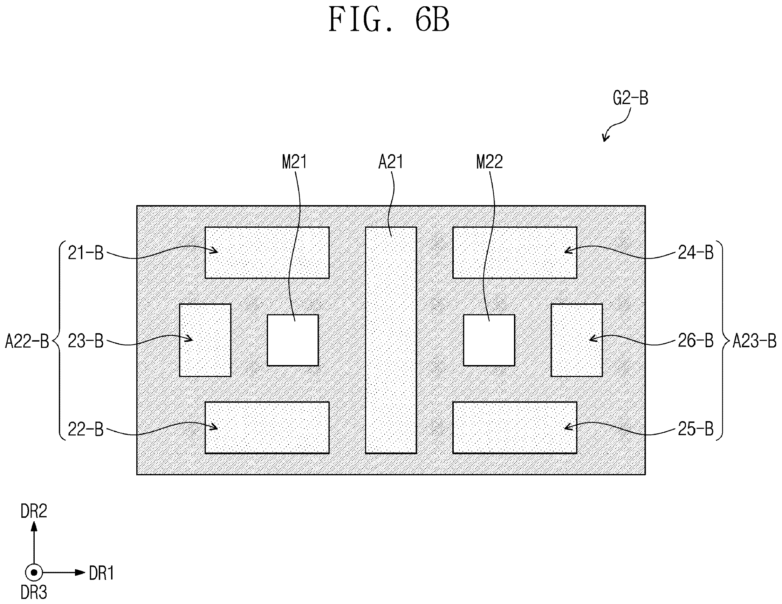

FIGS. 6A and 6B are enlarged plan views of portions of photomasks according to embodiments of the invention. FIGS. 6A and 6B are enlarged plan views of second group patterns G2-A and G2-B. In FIGS. 6A and 6B, the same reference numerals denote the same elements in FIGS. 4A and 4D, and thus, any repetitive detailed descriptions of the same elements will be omitted.

Referring to FIG. 6A, the second group pattern G2-A may include first and second main patterns M21 and M22 and first, second and third auxiliary patterns A21, A22-A, and A23-A. The above descriptions with reference to FIG. 4D may be equally applied to the first and second main patterns M21 and M22 and the first auxiliary pattern A21.

The second auxiliary pattern A22-A may include first, second and third sub-patterns 21-A, 22-A, and 23-A. The first and second sub-patterns 21-A and 22-A may extend in the first direction DR1 and may be spaced apart from each other with the first main pattern M21 interposed therebetween in the second direction DR2.

The third sub-pattern 23-A may extend in the second direction DR2 and may be spaced apart from the first main pattern M21 in the direction opposite to the first direction DR1. The third sub-pattern 23-A may extend from the first sub-pattern 21-A to the second sub-pattern 22-A. In an embodiment, the first, second and third sub-patterns 21-A, 22-A, and 23-A may be integrally provided or formed with each other as a single unitary and indivisible part.

The third auxiliary pattern A23-A may include fourth, fifth, and sixth sub-patterns 24-A, 25-A, and 26-A. The fourth and fifth sub-patterns 24-A and 25-A may extend in the first direction DR1 and may be spaced apart from each other with the second main pattern M22 interposed therebetween in the second direction DR2.

The sixth sub-pattern 26-A may extend in the second direction DR2 and may be spaced apart from the second main pattern M22 in the first direction DR1. The sixth sub-pattern 26-A may extend from the fourth sub-pattern 24-A to the fifth sub-pattern 25-A. In an embodiment, the fourth, fifth, and sixth sub-patterns 24-A, 25-A, and 26-A may be integrally provided or formed with each other as a single unitary and indivisible part.

Referring to FIG. 6B, the second group pattern G2-B may include first and second main patterns M21 and M22 and first, second and third auxiliary patterns A21, A22-B, and A23-B. The above descriptions with reference to FIG. 4A may be equally applied to the first and second main patterns M21 and M22 and the first auxiliary pattern A21.

The second auxiliary pattern A22-B may include first, second and third sub-patterns 21-B, 22-B, and 23-B. The first and second sub-patterns 21-B and 22-B may extend in the first direction DR1 and may be spaced apart from each other with the first main pattern M21 interposed therebetween in the second direction DR2.

The third sub-pattern 23-B may extend in the second direction DR2 and may be spaced apart from the first main pattern M21 in the direction opposite to the first direction DR1. In an embodiment, the third sub-pattern 23-B may be spaced apart from each of the first and second sub-patterns 21-B and 22-B. Each of the first, second and third sub-patterns 21-B, 22-B, and 23-B may have a rectangular shape.

A length of each of the first and second sub-patterns 21-B and 22-B in the first direction DR1 in which each of the first and second sub-patterns 21-B and 22-B extends may be greater than a length of the third sub-pattern 23-B in the second direction DR2 in which the third sub-pattern 23-B extends. However, the invention should not be limited thereto or thereby, and according to an alternative embodiment, the length of each of the first and second sub-patterns 21-B and 22-B in the first direction DR1 in which each of the first and second sub-patterns 21-B and 22-B extends may be equal to or smaller than the length of the third sub-pattern 23-B in the second direction DR2 in which the third sub-pattern 23-B extends.

The third auxiliary pattern A23-B may include fourth, fifth, and sixth sub-patterns 24-B, 25-B, and 26-B. The fourth and fifth sub-patterns 24-B and 25-B may extend in the first direction DR1 and may be spaced apart from each other with the second main pattern M22 interposed therebetween in the second direction DR2.

The sixth sub-pattern 26-B may extend in the second direction DR2 and may be spaced apart from the second main pattern M22 in the first direction DR1. The sixth sub-pattern 26-B may be spaced apart from each of the fourth and fifth sub-patterns 24-B and 25-B. Each of the fourth, fifth, and sixth sub-patterns 24-B, 25-B, and 26-B may have a rectangular shape.

A length of each of the fourth and fifth sub-patterns 24-B and 25-B in the first direction DR1 in which each of the fourth and fifth sub-patterns 24-B and 25-B extends may be greater than a length of the sixth sub-pattern 26-B in the second direction DR2 in which the sixth sub-pattern 26-B extends. However, the invention should not be limited thereto or thereby, and according to an alternative embodiment, the length of each of the fourth and fifth sub-patterns 24-B and 25-B in the first direction DR1 in which each of the fourth and fifth sub-patterns 24-B and 25-B extends may be equal to or smaller than the length of the sixth sub-pattern 26-B in the second direction DR2 in which the sixth sub-pattern 26-B extends.

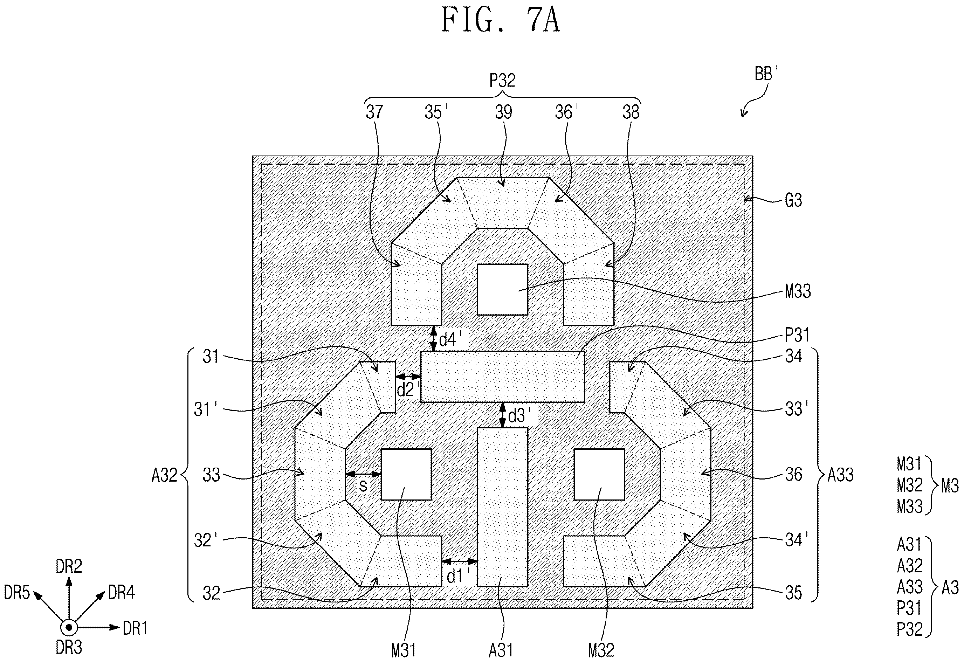

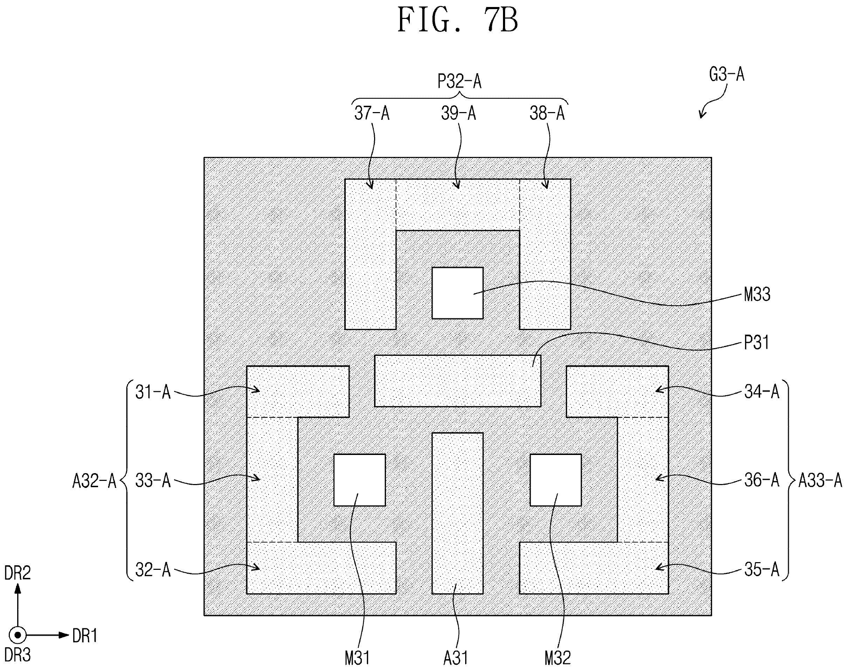

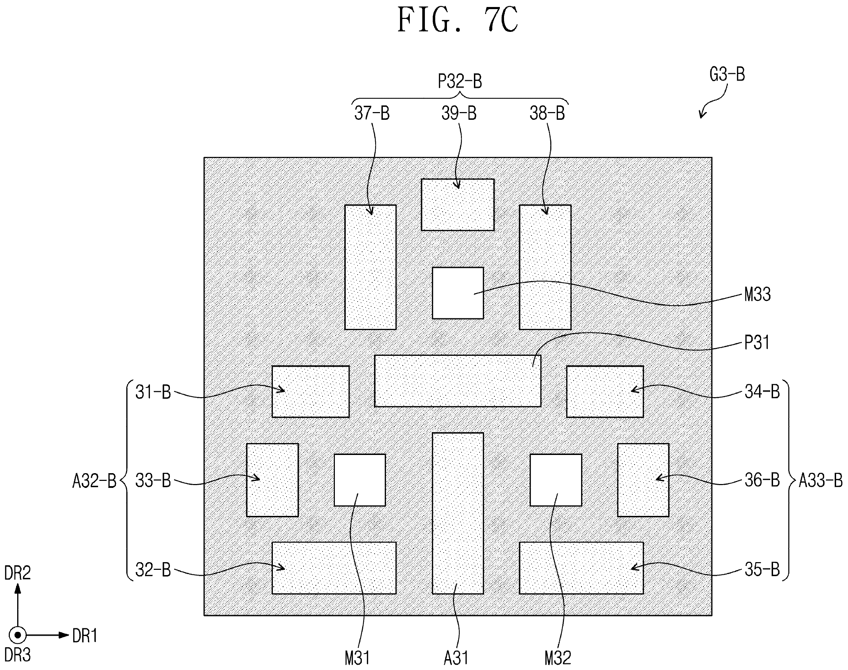

FIG. 7A is an enlarged plan view of a portion of the photomask in an area BB' of FIG. 1C according to an embodiment of the invention. FIGS. 7B and 7C are enlarged plan views of portions of photomasks according to embodiments of the invention. FIGS. 7A to 7C are enlarged plan views of third group patterns G3, G3-A, and G3-B.

Referring to FIG. 7A, the third group pattern G3 may include the third group main pattern M3 including three main patterns M31, M32, and M33 adjacent to each other and the third group auxiliary pattern A3. The third group main pattern M3 may include a first main pattern M31, a second main pattern M32, and a third main pattern M33. The third group auxiliary pattern A3 may include first, second and third auxiliary patterns A31, A32, and A33, a first additional auxiliary pattern P31, and a second additional auxiliary pattern P32.

The first and second main patterns M31 and M32 may be spaced apart from each other in the first direction DR1. The third main pattern M33 may be spaced apart from the first main pattern M31 in the fourth direction DR4 and may be spaced apart from the second main pattern M32 in the fifth direction DR5.

According to an embodiment, the third main pattern M33 may be disposed on an imaginary line extending from a center point between the first and second main patterns M31 and M32 in a direction (e.g., the second direction DR2) perpendicular to an imaginary line connected between the first and second main patterns M31 and M32, and a separation distance between the first and third main patterns M31 and M33 may be substantially the same as a separation distance between the second and third main patterns M32 and M33. In addition, each of the separation distance between the first and third main patterns M31 and M33 and the separation distance between the second and third main patterns M32 and M33 may be substantially the same as a separation distance between the first and second main patterns M31 and M32.

However, the invention should not be limited thereto or thereby. According to an embodiment, the separation distance between the first and third main patterns M31 and M33 may be different from the separation distance between the second and third main patterns M32 and M33, or the separation distance between the first and third main patterns M31 and M33 may be substantially the same as the separation distance between the second and third main patterns M32 and M33 but may be different from the separation distance between the first and second main patterns M31 and M32.

The first auxiliary pattern A31 may extend in the second direction DR2 and may be disposed between the first and second main patterns M31 and M32. The first auxiliary pattern A31 may have a rectangular shape.

The second auxiliary pattern A32 may be spaced apart from the first auxiliary pattern A31 with the first main pattern M31 interposed therebetween in the first direction DR1. The second auxiliary pattern A32 may surround the first main pattern M31. In an embodiment, the second auxiliary pattern A32 may face a portion of a first side portion and third and fourth side portions of the first main pattern M31.

In an embodiment, the second auxiliary pattern A32 may include a first sub-pattern 31, a second sub-pattern 32, a third sub-pattern 33, a first additional sub-pattern 31', and a second additional sub-pattern 32'. The first and second sub-patterns 31 and 32 may extend in the first direction DR1 and may be spaced apart from each other with the first main pattern M31 interposed therebetween in the second direction DR2. The third sub-pattern 33 may extend in the second direction DR2 and may be spaced apart from the first auxiliary pattern A31 with the first main pattern M31 interposed therebetween in the first direction DR1. Alternatively, the first sub-pattern 31 of the second auxiliary pattern A32 may be omitted.

The first additional sub-pattern 31' may extend from one end of the third sub-pattern 33 to one end of the first sub-pattern 31 in the fourth direction DR4. The second additional sub-pattern 32' may extend from another end of the third sub-pattern 33 to one end of the second sub-pattern 32 in the fifth direction DR5.

The third auxiliary pattern A33 may be spaced apart from the first auxiliary pattern A31 with the second main pattern M32 interposed therebetween in the first direction DR1. The third auxiliary pattern A33 may surround the second main pattern M32. In an embodiment, the third auxiliary pattern A33 may face a portion of a first side portion and second and third side portions of the second main pattern M32.

In an embodiment, the third auxiliary pattern A33 may include a fourth sub-pattern 34, a fifth sub-pattern 35, a sixth sub-pattern 36, a third additional sub-pattern 33', and a fourth additional sub-pattern 34'. The fourth and fifth sub-patterns 34 and 35 may extend in the first direction DR1 and may be spaced apart from each other with the second main pattern M32 interposed therebetween in the second direction DR2. The sixth sub-pattern 36 may extend in the second direction DR2 and may be spaced apart from the first auxiliary pattern A31 with the second main pattern M32 interposed therebetween in the first direction DR1. Alternatively, the fourth sub-pattern 34 of the third auxiliary pattern A33 may be omitted.

The third additional sub-pattern 33' may extend from one end of the sixth sub-pattern 36 to one end of the fourth sub-pattern 34 in the in the fifth direction DR5. The fourth additional sub-pattern 34' may extend from another end of the sixth sub-pattern 36 to one end of the fifth sub-pattern 35 in the fourth direction DR4.

The first additional auxiliary pattern P31 may be disposed between the first auxiliary pattern A31 and the third main pattern M33. The first additional auxiliary pattern P31 may be spaced apart from the first, second and third auxiliary patterns A31, A32, and A33. The first additional auxiliary pattern P31 may extend in the first direction DR1. The first additional auxiliary pattern P31 may have a quadrangular shape. The first additional auxiliary pattern P31 may have a rectangular shape defined by long sides extending in the first direction DR1 and short sides extending in the second direction DR2.

The second additional auxiliary pattern P32 may be spaced apart from the first additional auxiliary pattern P31 with the third main pattern M33 interposed therebetween in the second direction DR2. The second additional auxiliary pattern P32 may surround the third main pattern M33. In an embodiment, the second additional auxiliary pattern P32 may face first, second and fourth side portions of the third main pattern M33.

In an embodiment, the second additional auxiliary pattern P32 may include a seventh sub-pattern 37, an eighth sub-pattern 38, a ninth sub-pattern 39, a fifth additional sub-pattern 35', and a sixth additional sub-pattern 36'.

The seventh and eighth sub-patterns 37 and 38 may extend in the second direction DR2 and may be spaced apart from each other with the third main pattern M33 interposed therebetween in the first direction DR1. The seventh sub-pattern 37 may face the fourth side portion of the third main pattern M33, and the eighth sub-pattern 38 may face the second side portion of the third main pattern M33. The ninth sub-pattern 39 may extend in the first direction DR1 and may be spaced apart from the first additional auxiliary pattern P31 with the third main pattern M33 interposed therebetween in the second direction DR2.

The fifth additional sub-pattern 35' may extend from one end of the seventh sub-pattern 37 to one end of the ninth sub-pattern 39 in the fourth direction DR4. The sixth additional sub-pattern 36' may extend from one end of the eighth sub-pattern 38 to another end of the ninth sub-pattern 39 in the fifth direction DR5. In an embodiment, the seventh, eighth, and ninth sub-patterns 37, 38, and 39 and the fifth and sixth additional sub-patterns 35' and 36' may be integrally provided or formed with each other as a single unitary and indivisible part.

In an embodiment, each of a separation distance d1' between the first and second auxiliary patterns A31 and A32, a separation distance d2' between the second auxiliary pattern A32 and the first additional auxiliary pattern P31, a separation distance d3' between the first auxiliary pattern A31 and the first additional auxiliary pattern P31, and a separation distance d4' between the first and second additional auxiliary patterns P31 and P32 may be equal to or greater than about 0.5s, where s denotes a separation distance in the first direction DR1 between the first main pattern M31 and the second auxiliary pattern A32, as shown in FIG. 7A.

Referring to FIG. 7B, in an embodiment, the third group pattern G3-A may include first, second and third main patterns M31, M32, and M33, first, second and third auxiliary patterns A31, A32-A, and A33-A, and first and second additional auxiliary patterns P31 and P32-A. In such an embodiment, the first, second and third main patterns M31, M32, and M33, the first auxiliary pattern A31, and the first additional auxiliary pattern P31 are substantially the same as those described above with reference to FIG. 7A.

The second auxiliary pattern A32-A may include first, second and third sub-patterns 31-A, 32-A, and 33-A. The first and second sub-patterns 31-A and 32-A may extend in the first direction DR1 and may be spaced apart from each other with the first main pattern M31 interposed therebetween in the second direction DR2. The third sub-pattern 33-A may extend from the first sub-pattern 31-A to the second sub-pattern 32-A in the second direction DR2. In an embodiment, the first, second and third sub-patterns 31-A, 32-A, and 33-A may be integrally provided or formed with each other as a single unitary and indivisible part.

The third auxiliary pattern A33-A may include fourth, fifth, and sixth sub-patterns 34-A, 35-A, and 36-A. The fourth and fifth sub-patterns 34-A and 35-A may extend in the first direction DR1 and may be spaced apart from each other with the second main pattern M32 interposed therebetween in the second direction DR2. The sixth sub-pattern 36-A may extend from the fourth sub-pattern 34-A to the fifth sub-pattern 35-A in the second direction DR2. In an embodiment, the fourth, fifth, and sixth sub-patterns 34-A, 35-A, and 36-A may be integrally provided or formed with each other as a single unitary and indivisible part.

The second additional auxiliary pattern P32-A may include seventh, eighth, and ninth sub-patterns 37-A, 38-A, and 39-A. The seventh and eighth sub-patterns 37-A and 38-A may extend in the second direction DR2 and may be spaced apart from each other with the third main pattern M33 interposed therebetween in the first direction DR1. The ninth sub-pattern 39-A may extend from the seventh sub-pattern 37-A to the eighth sub-pattern 38-A in the first direction DR1. In an embodiment, the seventh, eighth, and ninth sub-patterns 37-A, 38-A, and 39-A may be integrally provided or formed with each other as a single unitary and indivisible part.

Referring to FIG. 7C, the third group pattern G3-B may include first, second and third main patterns M31, M32, and M33, first, second and third auxiliary patterns A31, A32-B, and A33-B, and first and second additional auxiliary patterns P31 and P32-B. In such an embodiment, the first, second and third main patterns M31, M32, and M33, the first auxiliary pattern A31, and the first additional auxiliary pattern P31 are substantially the same as those described above with reference to FIG. 7A.

The second auxiliary pattern A32-B may include first, second and third sub-patterns 31-B, 32-B, and 33-B. the first and second sub-patterns 31-B and 32-B may extend in the first direction DR1 and may be spaced apart from each other with the first main pattern M31 interposed therebetween in the second direction DR2. The third sub-pattern 33-B may extend in the second direction DR2 and may be spaced apart from each of the first and second sub-patterns 31-B and 32-B. Each of the first, second and third sub-patterns 31-B, 32-B, and 33-B may have a rectangular shape.

The third auxiliary pattern A33-B may include fourth, fifth, and sixth sub-patterns 34-B, 35-B, and 36-B. The fourth and fifth sub-patterns 34-B and 35-B may extend in the first direction DR1 and may be spaced apart from each other with the second main pattern M32 interposed therebetween in the second direction DR2. The sixth sub-pattern 36-B may extend in the second direction DR2 and may be spaced apart from each of the fourth and fifth sub-patterns 34-B and 35-B. Each of the fourth, fifth, and sixth sub-patterns 34-B, 35-B, and 36-B may have a rectangular shape.

The second additional auxiliary pattern P32-B may include seventh, eighth, and ninth sub-patterns 37-B, 38-B, and 39-B. The seventh and eighth sub-patterns 37-B and 38-B may extend in the second direction DR2 and may be spaced apart from each other with the third main pattern M33 interposed therebetween in the first direction DR1. The ninth sub-pattern 39-B may extend in the first direction DR1 and may be spaced apart from each of the seventh and eighth sub-patterns 37-B and 38-B. Each of the seventh, eighth, and ninth sub-patterns 37-B, 38-B, and 39-B may have a rectangular shape.

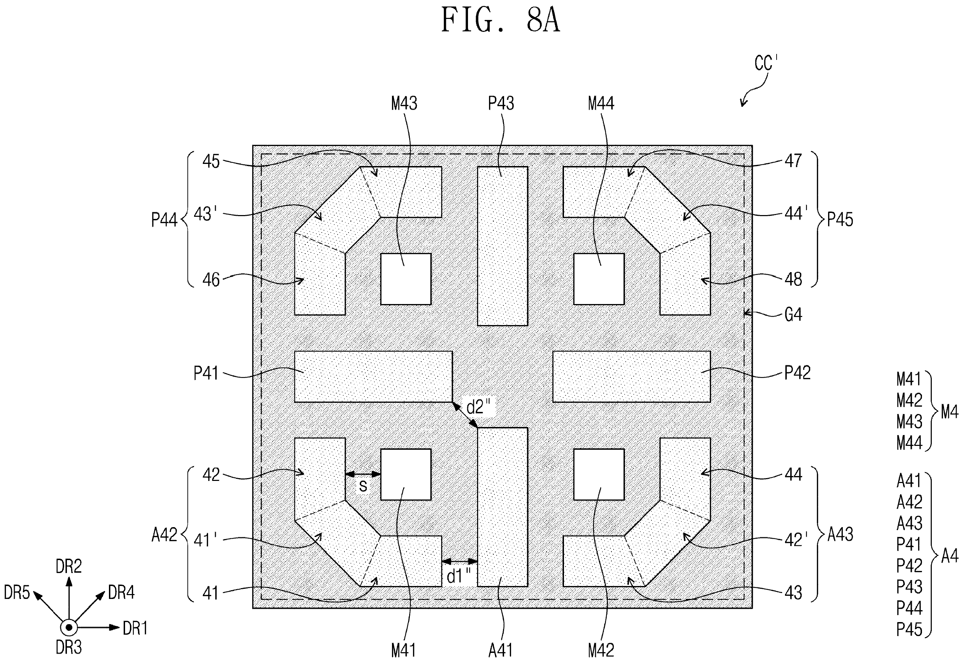

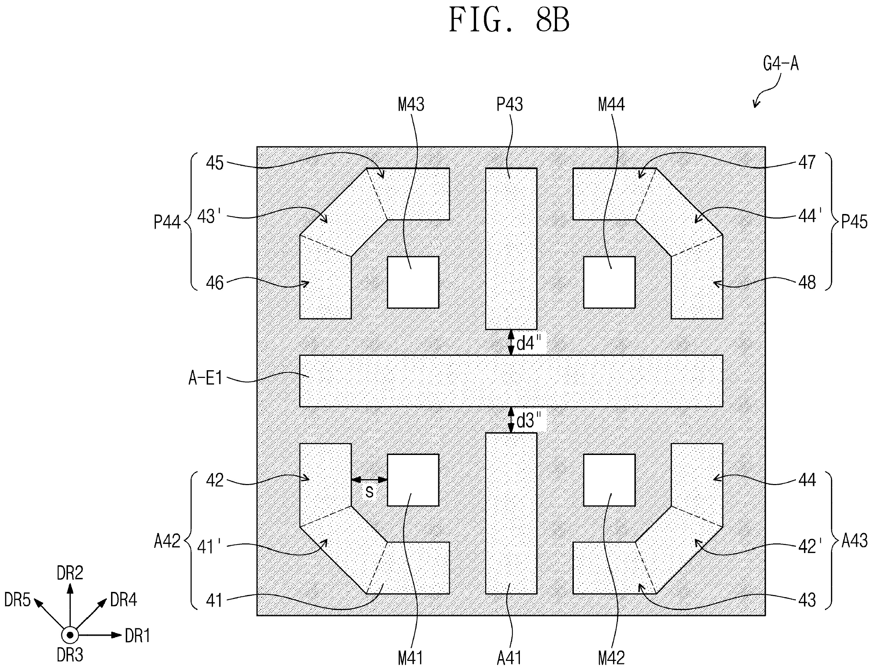

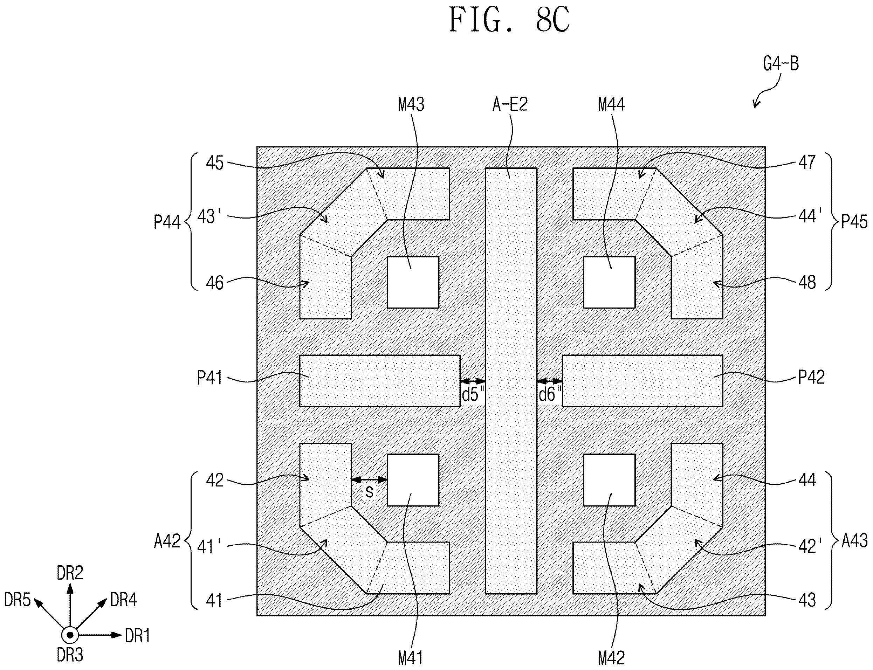

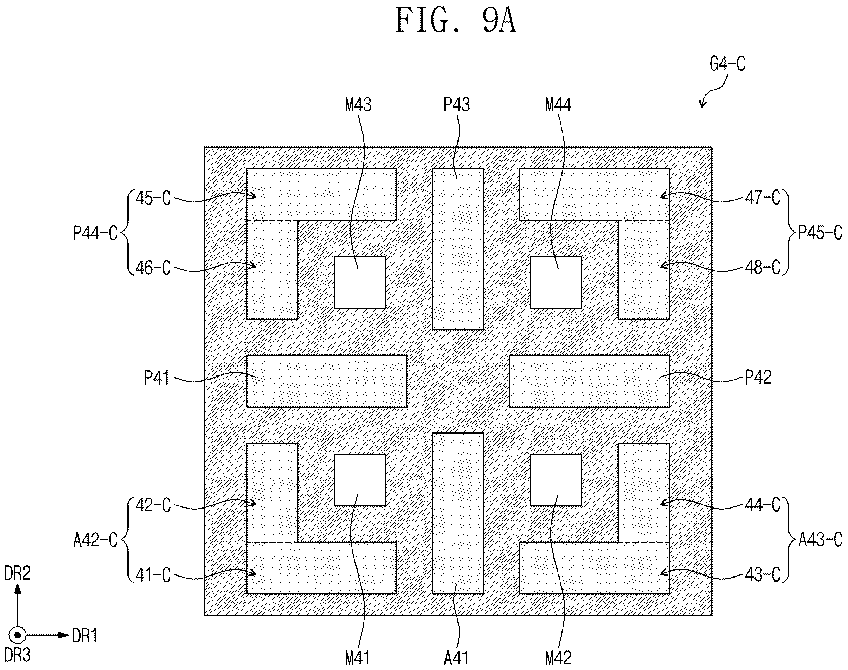

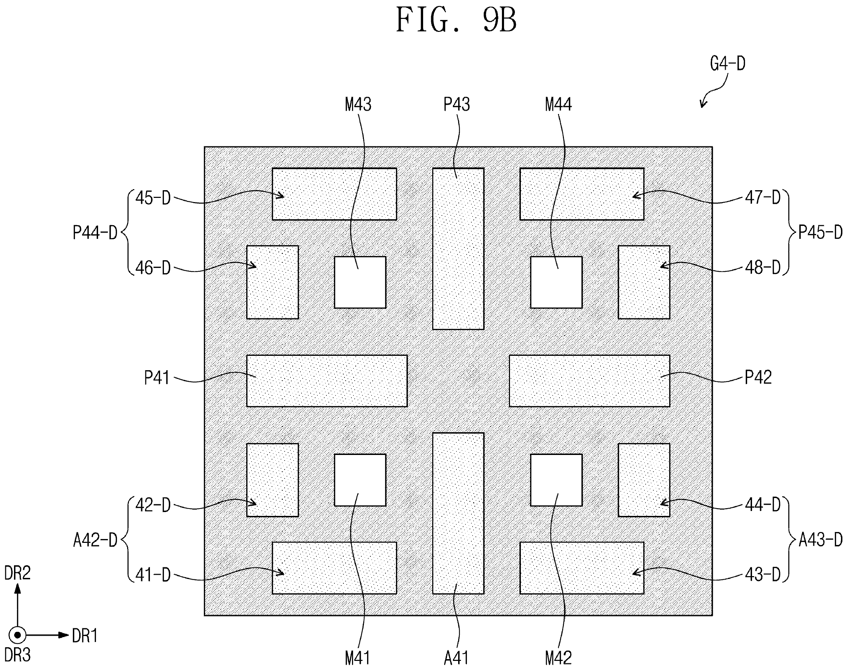

FIG. 8A is an enlarged plan view of a portion of the photomask in an area CC' of FIG. 1C according to an embodiment of the invention. FIGS. 8B and 8C are enlarged plan views of portions of photomasks according to embodiments of the invention. FIGS. 9A and 9B are enlarged plan views of portions of photomasks according to embodiments of the invention. FIGS. 8A to 8C, 9A, and 9B are enlarged plan views of fourth group patterns G4, G4-A, G4-B, G4-C, and G4-D.

Referring to FIG. 8A, in an embodiment, the fourth group pattern G4 may include the fourth group main pattern M4 including the four main patterns M41, M42, M43, and M44 adjacent to each other and the fourth group auxiliary pattern A4. The fourth group main pattern M4 may include a first main pattern M41, a second main pattern M42, a third main pattern M43, and a fourth main pattern M44. The fourth group auxiliary pattern A4 may include first, second and third auxiliary patterns A41, A42, and A43 and first, second, third, fourth, and fifth additional auxiliary patterns P41, P42, P43, P44, and P45.

The first and second main patterns M41 and M42 may be spaced apart from each other in the first direction DR1. The third main pattern M43 may be spaced apart from the first main pattern M41 in the second direction DR2, and the fourth main pattern M44 may be spaced apart from the second main pattern M42 in the second direction DR2. The third and fourth main patterns M43 and M44 may be spaced apart from each other in the first direction DR1.

According to an embodiment, a separation distance between the first and third main patterns M41 and M43 may be substantially the same as a separation distance between the second and fourth main patterns M42 and M44. In addition, each of the separation distance between the first and third main patterns M41 and M43 and the separation distance between the second and fourth main patterns M42 and M44 may be substantially the same as the separation distance between the first and second main patterns M41 and M42.

However, the invention should not be limited thereto or thereby. According to an alternative embodiment, the separation distance between the first and third main patterns M41 and M43 may be different from the separation distance between the second and fourth main patterns M42 and M44, or the separation distance between the first and third main patterns M41 and M43 may be substantially the same as the separation distance between the second and fourth main patterns M42 and M44 but may be different from the separation distance between the first and second main patterns M41 and M42.

The first auxiliary pattern A41 may extend in the second direction DR2 and may be disposed between the first and second main patterns M41 and M42. The first auxiliary pattern A41 may have a rectangular shape.

The second auxiliary pattern A42 may be spaced apart from the first auxiliary pattern A41 with the first main pattern M41 interposed therebetween in the first direction DR1. The second auxiliary pattern A42 may surround the first main pattern M41. In an embodiment, the second auxiliary pattern A42 may face third and fourth side portions of the first main pattern M41.

In an embodiment, the second auxiliary pattern A42 may include first and second sub-patterns 41 and 42 and a first additional sub-pattern 41'. The first sub-pattern 41 may extend in the first direction DR1 and may face the third side portion of the first main pattern M41. The second sub-pattern 42 may extend in the second direction DR2 and may face the fourth side portion of the first main pattern M41. The first additional sub-pattern 41' may extend from one end of the first sub-pattern 41 to one end of the second sub-pattern 42 in the fifth direction DR5.

The third auxiliary pattern A43 may be spaced apart from the first auxiliary pattern A41 with the second main pattern M42 interposed therebetween in the first direction DR1. The third auxiliary pattern A43 may surround the second main pattern M42. In an embodiment, the third auxiliary pattern A43 may face the second and third side portions of the second main pattern M42.

In an embodiment, the third auxiliary pattern A43 may include third and fourth sub-patterns 43 and 44 and a second additional sub-pattern 42'. The third sub-pattern 43 may extend in the first direction DR1 and may face the third side portion of the second main pattern M42. The fourth sub-pattern 44 may extend in the second direction DR2 and may face the second side portion of the second main pattern M42. The second additional sub-pattern 42' may extend from one end of the third sub-pattern 43 to one end of the fourth sub-pattern 44 in the fourth direction DR4.

The first additional auxiliary pattern P41 may extend in the first direction DR1 and may be disposed between the first and third main patterns M41 and M43. The first additional auxiliary pattern P41 may be spaced apart from the first, second and third auxiliary patterns A41, A42, and A43. The first additional auxiliary pattern P41 may have a rectangular shape.

The second additional auxiliary pattern P42 may extend in the first direction DR1 and may be disposed between the second and fourth main patterns M42 and M44. The second additional auxiliary pattern P42 may be spaced apart from the first, second and third auxiliary patterns A41, A42, and A43 and the first additional auxiliary pattern P41. The second additional auxiliary pattern P42 may have a rectangular shape.

The third additional auxiliary pattern P43 may extend in the second direction DR2 and may be disposed between the third and fourth main patterns M43 and M44. The third additional auxiliary pattern P43 may be spaced apart from the first, second and third auxiliary patterns A41, A42, and A43 and the first and second additional auxiliary patterns P41 and P42. That is, the first auxiliary pattern A41 and the first, second and third additional auxiliary patterns P41, P42, and P43 may be spaced apart from each other. The third additional auxiliary pattern P43 may have a rectangular shape.

The fourth additional auxiliary pattern P44 may be spaced apart from the first additional auxiliary pattern P41 with the third main pattern M43 interposed therebetween in the second direction DR2 and may be spaced apart from the third additional auxiliary pattern P43 with the third main pattern M43 interposed therebetween in the first direction DR1. The fourth additional auxiliary pattern P44 may surround the third main pattern M43. In an embodiment, the fourth additional auxiliary pattern P44 may face first and fourth side portions of the third main pattern M43.

In an embodiment, the fourth additional auxiliary pattern P44 may include fifth and sixth sub-patterns 45 and 46 and a third additional sub-pattern 43'. The fifth sub-pattern 45 may extend in the first direction DR1 and may face a first side portion of the third main pattern M43. The sixth sub-pattern 46 may extend in the second direction DR2 and may face the fourth side portion of the third main pattern M43. The third additional sub-pattern 43' may extend from one end of the fifth sub-pattern 45 to one end of the sixth sub-pattern 46 in the fourth direction DR4.

The fifth additional auxiliary pattern P45 may be spaced apart from the second additional auxiliary pattern P42 with the fourth main pattern M44 interposed therebetween in the second direction DR2 and may be spaced apart from the third additional auxiliary pattern P43 with the fourth main pattern M44 interposed therebetween in the first direction DR1. The fifth additional auxiliary pattern P45 may surround the fourth main pattern M44. In an embodiment, the fifth additional auxiliary pattern P45 may face first and second side portions of the fourth main pattern M44.

In an embodiment, the fifth additional auxiliary pattern P45 may include seventh and eighth sub-patterns 47 and 48 and a fourth additional sub-pattern 44'. The seventh sub-pattern 47 may extend in the first direction DR1 and may face the first side portion of the fourth main pattern M44. The eighth sub-pattern 48 may extend in the second direction DR2 and may face the second side portion of the fourth main pattern M44. The fourth additional sub-pattern 44' may extend from one end of the seventh sub-pattern 47 to one end of the eighth sub-pattern 48 in the fifth direction DR5.

In an embodiment, each of a separation distance d1" between the first auxiliary pattern A41 and the second auxiliary pattern A42 and a separation distance d2" between the first auxiliary pattern A41 and the first additional auxiliary pattern P41 may be equal to or greater than about 0.5s, where s denotes a separation distance in the first direction DR1 between the first main pattern M41 and the second auxiliary pattern A42, as shown in FIG. 8A. However, the separation distance equal to or greater than about 0.5s should not be limited to the separation distance between the first auxiliary pattern A41 and other auxiliary patterns adjacent to the first auxiliary pattern A41 and may be applied to the third auxiliary pattern A43 and the fourth and fifth additional auxiliary patterns P44 and P45.

Referring to FIG. 8B, in an embodiment, the fourth group pattern G4-A may include first, second, third, and fourth main patterns M41, M42, M43, and M44, first, second and third auxiliary patterns A41, A42, and A43, third, fourth, and fifth additional auxiliary patterns P43, P44, and P45, and an extension auxiliary pattern A-E1. In such an embodiment, the first, second, third, and fourth main patterns M41, M42, M43, and M44 and the third, fourth, and fifth additional auxiliary patterns P43, P44, and P45 are substantially the same as those described above with reference to FIG. 8A.

In an embodiment, the extension auxiliary pattern A-E1 may extend in the first direction DR1 and may be disposed between the first and third main patterns M41 and M43 and between the second and fourth main patterns M42 and M44. In addition, the extension auxiliary pattern A-E1 may be disposed between the first auxiliary pattern A41 and the third additional auxiliary pattern P43. That is, the first and second additional auxiliary patterns P41 and P42 described with reference to FIG. 8A may be integrally provided or formed with each other as a single unitary and indivisible part.

In an embodiment, each of a separation distance d3" between the extension auxiliary pattern A-E1 and the first auxiliary pattern A41 and a separation distance d4" between the extension auxiliary pattern A-E1 and the third additional auxiliary pattern P43 may be equal to or greater than about 0.5s, where s denotes a separation distance in the first direction DR1 between the first main pattern M41 and the second auxiliary pattern A42, as shown in FIG. 8B.

Referring to FIG. 8C, in an embodiment, the fourth group pattern G4-B may include first, second, third, and fourth main patterns M41, M42, M43, and M44, second and third auxiliary patterns A42 and A43, first and second additional auxiliary patterns P41 and P42, fourth and fifth additional auxiliary patterns P44 and P45, and an extension auxiliary pattern A-E2. In such an embodiment, the first, second, third, and fourth main patterns M41, M42, M43, and M44, the second and third auxiliary patterns A42 and A43, the first and second additional auxiliary patterns P41 and P42, and the fourth and fifth additional auxiliary patterns P44 and P45 are substantially the same as those described above with reference to FIG. 8A.

In an embodiment, the extension auxiliary pattern A-E2 may extend in the second direction DR2 and may be disposed between the first and second main patterns M41 and M42 and between the third and fourth main patterns M43 and M44. In addition, the extension auxiliary pattern A-E2 may be disposed between the first and second additional auxiliary patterns P41 and P42. That is, the first auxiliary pattern A41 and the third additional auxiliary pattern P43 described with reference to FIG. 8A may be integrally provided or formed with each other as a single unitary and indivisible part.

In the embodiment, each of a separation distance d5" between the extension auxiliary pattern A-E2 and the first additional auxiliary pattern P41 and a separation distance d6" between the extension auxiliary pattern A-E2 and the second additional auxiliary pattern P42 may be equal to or greater than about 0.5s, where s denotes a separation distance in the first direction DR1 between the first main pattern M41 and the second auxiliary pattern A42, as shown in FIG. 8C.

Referring to FIG. 9A, in an embodiment, the fourth group pattern G4-C may include first, second, third, and fourth main patterns M41, M42, M43, and M44, first, second and third auxiliary patterns A41, A42-C, and A43-C, and first, second, third, fourth, and fifth additional auxiliary patterns P41, P42, P43, P44-C, and P45-C. In such an embodiment, the first, second, third, and fourth main patterns M41, M42, M43, and M44, the first auxiliary pattern A41, and the first, second and third additional auxiliary patterns P41, P42, and P43 are substantially the same as those described above with reference to FIG. 8A.

The second auxiliary pattern A42-C may include first and second sub-patterns 41-C and 42-C. The first sub-pattern 41-C may extend in the first direction DR1 and may be spaced apart from the first additional auxiliary pattern P41 with the first main pattern M41 interposed therebetween in the second direction DR2. The second sub-pattern 42-C may extend in the second direction DR2 and may be spaced apart from the first auxiliary pattern A41 with the first main pattern M41 interposed therebetween in the first direction DR1. In an embodiment, the first and second sub-patterns 41-C and 42-C may be integrally provided or formed with each other as a single unitary and indivisible part.

The third auxiliary pattern A43-C may include third and fourth sub-patterns 43-C and 44-C. The third sub-pattern 43-C may extend in the first direction DR1 and may be spaced apart from the second additional auxiliary pattern P42 with the second main pattern M42 interposed therebetween in the second direction DR2. The fourth sub-pattern 44-C may extend in the second direction DR2 and may be spaced apart from the first auxiliary pattern A41 with the second main pattern M42 interposed therebetween in the first direction DR1. In an embodiment, the third and fourth sub-patterns 43-C and 44-C may be integrally provided or formed with each other as a single unitary and indivisible part.

The fourth additional auxiliary pattern P44-C may include fifth and sixth sub-patterns 45-C and 46-C. The fifth sub-pattern 45-C may extend in the first direction DR1 and may be spaced apart from the first additional auxiliary pattern P41 with the third main pattern M43 interposed therebetween in the second direction DR2. The sixth sub-pattern 46-C may extend in the second direction DR2 and may be spaced apart from the third additional auxiliary pattern P43 with the third main pattern M43 interposed therebetween in the first direction DR1. In an embodiment, the fifth and sixth sub-patterns 45-C and 46-C may be integrally provided or formed with each other as a single unitary and indivisible part.

The fifth additional auxiliary pattern P45-C may include seventh and eighth sub-patterns 47-C and 48-C. The seventh sub-pattern 47-C may extend in the first direction DR1 and may be spaced apart from the second additional auxiliary pattern P42 with the fourth main pattern M44 interposed therebetween in the second direction DR2. The eighth sub-pattern 48-C may extend in the second direction DR2 and may be spaced apart from the third additional auxiliary pattern P43 with the fourth main pattern M44 interposed therebetween in the first direction DR1. In an embodiment, the seventh and eighth sub-patterns 47-C and 48-C may be integrally provided or formed with each other as a single unitary and indivisible part.

Referring to FIG. 9B, in an embodiment, the fourth group pattern G4-D may include first, second, third, and fourth main patterns M41, M42, M43, and M44, first, second and third auxiliary patterns A41, A42-D, and A43-D, and first, second, third, fourth, and fifth additional auxiliary patterns P41, P42, P43, P44-D, and P45-D. In such an embodiment, the first, second, third, and fourth main patterns M41, M42, M43, and M44, the first auxiliary pattern A41, and the first, second and third additional auxiliary patterns P41, P42, and P43 are substantially the same as those described above with reference to FIG. 8A.

The second auxiliary pattern A42-D may include a first sub-pattern 41-D extending in the first direction DR1 and a second sub-pattern 42-D extending in the second direction DR2. In an embodiment, the first and second sub-patterns 41-D and 42-D may be spaced apart from each other. The first and second sub-patterns 41-D and 42-D may have a quadrangular shape.

The third auxiliary pattern A43-D may include a third sub-pattern 43-D extending in the first direction DR1 and a fourth sub-pattern 44-D extending in the second direction DR2. In an embodiment, the third and fourth sub-patterns 43-D and 44-D may be spaced apart from each other. The third and fourth sub-patterns 43-D and 44-D may have a quadrangular shape.

The fourth additional auxiliary pattern P44-D may include a fifth sub-pattern 45-D extending in the first direction DR1 and a sixth sub-pattern 46-D extending in the second direction DR2. In an embodiment, the fifth and sixth sub-patterns 45-D and 46-D may be spaced apart from each other. The fifth and sixth sub-patterns 45-D and 46-D may have a quadrangular shape.

The fifth additional auxiliary pattern P45-D may include a seventh sub-pattern 47-D extending in the first direction DR1 and an eighth sub-pattern 48-D extending in the second direction DR2. In an embodiment, the seventh and eighth sub-patterns 47-D and 48-D may be spaced apart from each other. The seventh and eighth sub-patterns 47-D and 48-D may have a quadrangular shape.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A photomask (PM) comprising:

   a first light-transmitting portion (TP1) comprising first and second main patterns (M21, M31, M41, M22, M32, M42) spaced apart from each other in a first direction (DR1);
   a second light-transmitting portion (TP2) having a light transmittance lower than a light transmittance of the first light-transmitting portion (TP1) and comprising a first auxiliary pattern (A21, A31, A41) disposed between the first and second main patterns (M21, M31, M41, M22, M32, M42) and extending in a second direction (DR2) crossing the first direction (DR1), a second auxiliary pattern (A22, A32, A42) spaced apart from the first auxiliary pattern (A21, A31, A41) in the first direction (DR1) with the first main pattern (M21, M31, M41) interposed therebetween and surrounding the first main pattern (M21, M31, M41), and a third auxiliary pattern (A23, A33, A43) spaced apart from the first auxiliary pattern (A21, A31, A41) in the first direction (DR1) with the second main pattern (M22, M32, M42) interposed therebetween and surrounding the second main pattern (M22, M32, M42); and
   a light shielding portion (SP) surrounding the first and second light-transmitting portions (TP1, TP2),
   wherein the first auxiliary pattern (A21, A31, A41), the first main pattern (M21, M31, M41), and the second auxiliary pattern (A22, A32, A42) satisfy the following Equation: $1 \geq h + s$,
   wherein 1 denotes a length in the second direction (DR2) of the first auxiliary pattern (A21, A31, A41),
   h denotes a maximum width in one of the first and second directions (DR1, DR2) of the first main pattern (M21, M31, M41), and
   s denotes a separation distance in the first direction (DR1) between the first main pattern (M21, M31, M41) and the second auxiliary pattern (A22, A32, A42).

2. The photomask (PM) of claim 1, wherein

the second auxiliary pattern (A22) comprises:

> a first sub-pattern (21) extending in the first direction (DR1);
> a second sub-pattern (22) extending in the first direction (DR1) and spaced apart from the first sub-pattern (21) in the second direction (DR2) with the first main pattern (M21) interposed therebetween; and
> a third sub-pattern (23) extending in the second direction (DR2),

the third auxiliary pattern (A23) comprises:

> a fourth sub-pattern (24) extending in the first direction (DR1);
> a fifth sub-pattern (25) extending in the first direction (DR1) and spaced apart from the fourth sub-pattern (24) in the second direction (DR2) with the second main pattern (M22) interposed therebetween; and
> a sixth sub-pattern (26) extending in the second direction (DR2) and spaced apart from the first auxiliary pattern (A21) with the second main pattern (M22) interposed therebetween in the first direction (DR1).

3. The photomask (PM) of claim 2, wherein the first, second and third sub-patterns (21, 22, 23) are integrally formed with each other as a single unitary and indivisible part or are spaced apart from each other.

4. The photomask (PM) of claim 2, wherein the second auxiliary pattern (A22) further comprises:

> a first additional sub-pattern (21') extending from one end of the first sub-pattern (21) to one end of the third sub-pattern (23) in an oblique direction of the first direction (DR1); and
> a second additional sub-pattern (22') extending from one end of the second sub-pattern (22) to another end of the third sub-pattern (23) in a direction crossing the oblique direction.

5. The photomask (PM) of at least one of claims 1 to 4, wherein the first auxiliary pattern (A21) has a rectangular shape.

6. The photomask (PM) of at least one of claims 2 to 5, further comprising:

> a third main pattern (M33) spaced apart from the first auxiliary pattern (A31) in the second direction (DR2);
> a first additional auxiliary pattern (P31) extending in the first direction (DR1), disposed between the first auxiliary pattern (A31) and the third main pattern (M33), and spaced apart from the first, second and third auxiliary patterns (A31, A32, A33); and
a second additional auxiliary pattern (P32) spaced apart from the first additional auxiliary pattern (P31) in the second direction (DR2) with the third main pattern (M33) interposed therebetween and surrounding the third main pattern (M33).

7. The photomask (PM) of claim 6, wherein the second additional auxiliary pattern (P32) comprises:

> a seventh sub-pattern (37) extending in the second direction (DR2);
> an eighth sub-pattern (38) extending in the second direction (DR2) and spaced apart from the seventh sub-pattern (37) in the first direction (DR1) with the third main pattern (M33) interposed therebetween; and
> a ninth sub-pattern (39) extending in the first direction (DR1).

8. The photomask (PM) of claim 7, wherein the seventh, eighth, and ninth sub-patterns (37, 38, 39) are integrally formed with each other as a single unitary and indivisible part or are spaced apart from each other.

9. The photomask (PM) of claim 7, wherein the second additional auxiliary pattern (P32) further comprises:

> a fifth additional sub-pattern (35') extending from one end of the seventh sub-pattern (37) to one end of the ninth sub-pattern (39) in an oblique direction of the first direction (DR1); and
> a sixth additional sub-pattern (36') extending from one end of the eighth sub-pattern (38) to another end of the ninth sub-pattern (39) in a direction crossing the oblique direction.

10. The photomask (PM) of claim 1, further comprising:

> a third main pattern (M43) spaced apart from the first main pattern (M41) in the second direction (DR2);
> a fourth main pattern (M44) spaced apart from the second main pattern (M42) in the second direction (DR2);
> a first additional auxiliary pattern (P41) extending in the first direction (DR1), disposed between the first and third main patterns (M41, M43), and spaced apart from the first, second and third auxiliary patterns (A41, A42, A43);
> a second additional auxiliary pattern (P42) extending in the first direction (DR1), disposed between the second and fourth main patterns (M42, M44), and spaced apart from the first, second and third auxiliary patterns (A41, A42, A43);

a third additional auxiliary pattern (P43) extending in the second direction (DR2) and disposed between the third and fourth main patterns (M43, M44);

a fourth additional auxiliary pattern (P44) spaced apart from the first additional auxiliary pattern (P41) in the second direction (DR2) with the third main pattern (M43) interposed therebetween and surrounding the third main pattern (M43); and

a fifth additional auxiliary pattern (P45) spaced apart from the second additional auxiliary pattern (A42) in the second direction (DR2) with the fourth main pattern (M44) interposed therebetween and surrounding the fourth main pattern (M44).

11. The photomask (PM) of claim 10, wherein the second auxiliary pattern (A42) comprises:

a first sub-pattern (41) extending in the first direction (DR1) and spaced apart from the first additional auxiliary pattern (P41) in the second direction (DR2) with the first main pattern (M41) interposed therebetween; and

a second sub-pattern (42) extending in the second direction (DR2), and the fourth additional auxiliary pattern (P44) comprises:

a fifth sub-pattern (45) extending in the first direction (DR1) and spaced apart from the first additional auxiliary pattern (P41) in the second direction (DR2) with the third main pattern (M43) interposed therebetween; and

a sixth sub-pattern (46) extending in the second direction (DR2).

12. The photomask (PM) of claim 11, wherein

the first and second sub-patterns (41, 42) are integrally formed with each other as a single unitary and indivisible part, and the fifth and sixth sub-patterns (45, 46) are integrally formed with each other as a single unitary and indivisible part.

13. The photomask (PM) of claim 11, wherein

the first and second sub-patterns (41, 42) are spaced apart from each other, and the fifth and sixth sub-patterns (45, 46) are spaced apart from each other.

14. The photomask (PM) of claim 11, wherein

the fourth additional auxiliary pattern (P44) further comprises a third additional sub-pattern (43') extending from one end of the fifth sub-pattern (45) to one end of the sixth sub-pattern (46) in an oblique direction of the first direction (DR1), and

the second auxiliary pattern (A42) further comprises a first additional sub-pattern (41') extending from one end of the first sub-pattern (41) to one end of the second sub-pattern (42) in a direction crossing the oblique direction.

15. The photomask (PM) of at least one of claims 10 to 14, wherein the first auxiliary pattern (A41) and the first, second and third additional auxiliary patterns (P41, P42, P43) are spaced apart from each other.

16. The photomask (PM) of at least one of claims 10 to 14, wherein

the first auxiliary pattern (A41) and the third additional auxiliary pattern (P43) are integrally formed with each other as a single unitary and indivisible part, or

the first additional auxiliary pattern (P41) and the second additional auxiliary pattern (P42) are integrally formed with each other as a single unitary and indivisible part.

17. The photomask (PM) of at least one of claims 1 to 16, wherein each of the first and second main patterns (M41, M42) has a quadrangular shape or an octagonal shape.

18. The photomask (PM) of at least one of claims 1 to 17, further comprising:

a transparent base substrate (BS);

a light transmitting layer (LL), having a light transmittance lower than a light transmittance of the transparent base substrate (BS), and disposed on the transparent base substrate (BS), wherein first and second main openings (OP2-M1, OP2-M2) are defined through the light transmitting layer (LL); and

a light blocking layer (UL) disposed on the light transmitting layer (LL), wherein a third main opening (OP2-M3) corresponding to the first main opening (OP2-M1), a fourth main opening (OP2-M4) corresponding to the second main opening (OP2-M2), and first, second and third auxiliary openings (OP2-A1, OP2-A2. OP2-A3) are defined through the light blocking layer (UL), wherein portions of the transparent base substrate (BS), which are exposed through the first and third main openings (OP2-M1, OP2-M3), correspond to the first main pattern (M21, M31, M41),

portions of the transparent base substrate (BS), which are exposed through the second and fourth main openings (OP2-M2, OP2-M4), correspond to the second main pattern (M22, M32, M42),

a portion of the light transmitting layer (LL), which is exposed through the first auxiliary opening (OP2-A1), corresponds to the first auxiliary pattern (A21, A31, A41),

a portion of the light transmitting layer (LL), which is exposed through the second auxiliary opening (OP2-A2), corresponds to the second auxiliary pattern (A22, A32, A42), and

a portion of the light transmitting layer (LL), which is exposed through the third auxiliary opening (OP2-A3), corresponds to the third auxiliary pattern (A23, A33, A43).

19. The photomask (PM) of claim 18, wherein the light transmitting layer (LL) comprises at least one selected from Mo, Si, and Cr.

20. The photomask (PM) of at least one of claims 1 to 19, wherein the second light-transmitting portion (TP2) has a light transmittance equal to or greater than about 3% and equal to or smaller than about 60%.

21. The photomask (PM) of at least one of claims 1 to 20, wherein a phase of a light passing through the second light-transmitting portion (TP2) is changed by about 100 degrees or more and about 300 degrees or less.

22. The photomask (PM) of at least one of claims 1 to 21, wherein the first and second main patterns (M22, M32, M42) and the second auxiliary pattern (A22, A32, A42) satisfy the following Equation: $2s \leq w \leq h+2(s+p)$, wherein w denotes a separation distance between the first and second main patterns (M21, M31, M41, M22, M32, M42), and p denotes a minimum width in the first direction (DR1) of the second auxiliary pattern (A22, A32, A42).

23. The photomask (PM) of at least one of claims 1 to 22, wherein

the first and second auxiliary patterns (A21, A31, A41, A22, A32, A42) satisfy the following Equation: $d1 \geq 0.5s$, wherein d1 denotes a separation distance between the first and second auxiliary patterns (A22, A32, A42),

the first and third auxiliary patterns (A21, A31, A41, A23, A33, A43) satisfy the following Equation: $d2 \geq 0.5s$, wherein d2 denotes a separation distance between the first and third auxiliary patterns (A21, A31, A41, A23, A33, A43).

24. A method of manufacturing a display panel (DP), the method comprising:

preparing a preliminary display panel (DP-I) comprising a base layer (BL), a conductive pattern disposed on the base layer (BL), at least one insulating layer disposed on the conductive pattern, and a resist layer (PR) disposed on the at least one insulating layer;

placing a photomask (PM) on the preliminary display panel (DP-I), wherein the photomask (PM) comprises a first light-transmitting portion (TP1) comprising first and second main patterns (M21, M31, M41, M22, M32, M42) spaced apart from each other in a first direction (DR1), a second light-transmitting portion (TP2) spaced apart from the first light-transmitting portion (TP1) and having a light transmittance lower than a light transmittance of the first light-transmitting portion (TP1), and a light shielding portion (SP) surrounding the first and second light-transmitting portions (TP1, TP2);

radiating a light to the photomask (PM) to pattern the resist layer (PR) such that first and second exposure openings (OP-P2, OP-P3) are formed through the resist layer (PR) to respectively correspond to the first and second main patterns (M21, M31, M41, M22, M32, M42); and

patterning the at least one insulating layer to form first and second contact holes (CNT2, CNT3) through the at least one insulating layer to respectively correspond to the first and second exposure openings (OP-P2, OP-P3),

wherein the second light-transmitting portion (TP2) of the photomask (PM) comprises a first auxiliary pattern (A21, A31, A41) disposed between the first and second main patterns (M21, M31, M41, M22, M32, M42) and extending in a second direction (DR2) crossing the first direction (DR1), a second auxiliary pattern (A22, A32, A42) spaced apart from the first auxiliary pattern (A21, A31, A41) in the first direction (DR1) with the first main pattern (M21, M31, M41) interposed therebetween, and a third auxiliary pattern (A23, A33, A43) spaced apart from the first auxiliary pattern (A21, A31, A41) in the first direction (DR1) with the second main pattern (M22, M32, M42) interposed therebetween,

the first auxiliary pattern (A21, A31, A41), the first main pattern (M21, M31, M41), and the second auxiliary pattern (A22, A32, A42) satisfy the following Equation: $1 \geq h + s$, wherein 1 denotes a length in the second direction (DR2) of the first auxiliary pattern (A21, A31, A41), h denotes a maximum width in one of the first and second directions (DR2) of the first main pattern (M21, M31, M41), and s denotes a separation distance in the first direction (DR1) between the first main pattern (M21, M31, M41) and the second auxiliary pattern (A22, A32, A42).

# FIG. 1A

DR3
DR2 ← → DR1

# FIG. 1B

DR3
⊗ → DR1
DR2

# FIG. 1C

# FIG. 2A

# FIG. 2B

DP

NPXA | PXA | NPXA

TFE

AE   EM   CE

DP-OL

OP-PDL

PDL

CNT4

INS12

INS11

DP-CL

INS10

BFL

BL

CNE1  BML  Sa  Ga  Aa  Da  GI  CNE2

CNT2 CNT3        TR        CNT1

DR3

AE
EM  } OL
CE

# FIG. 3A

# FIG. 3B

EP 4 321 930 A1

# FIG. 3C

EP 4 321 930 A1

# FIG. 3D

PM

OP-M    OP-A

UL
LL
BS

DP-I

M21    M22    A2    M1    A1

PR

INS10

DP-CLI

BFL

BL

DR3

BML    Sa  Ga  Aa  Da  GI

TR

M21
M22  } M2

EP 4 321 930 A1

# FIG. 3E

EP 4 321 930 A1

EP 4 321 930 A1

# FIG. 3F

DP-I

OP-P2    OP-P3              OP-P1

PR

CNT2    CNT3              CNT1

DP-CLI

INS10

BFL

BL

DR3

BML   Sa   Ga   Aa  Da   GI

TR

EP 4 321 930 A1

# FIG. 3G

# FIG. 3H

QQ'

G2-CNT    G1-CNT

C21

C22

C1

G1-CNT
C1

G3-CNT
C33
C31
C32

G4-CNT
C43
C44
C42
C41

G1-CNT
C1

DR2

DR3 ● DR1

# FIG. 3I

DP

NPXA | PXA | NPXA

TFE

AE   EM   CE

DP-OL

OP-PDL

PDL

CNT4

INS12

INS11

DP-CL

INS10

BFL

BL

CNE1 | BML | Sa  Ga  Aa  Da | GI | CNE2

CNT2  CNT3 | TR | CNT1

DR3

AE
EM } OL
CE

# FIG. 4A

EP 4 321 930 A1

# FIG. 4B

PM

OP1-M1

OP1-M2    OP1-A

UL

LL

BS

II                II'

M1          A1

DR3

DR1

DR2

# FIG. 4C

PM

OP2-A2    OP2-M1    OP2-A1    OP2-M2

OP2-M3              OP2-M4    OP2-A3

UL

LL

BS

III                                        III'

A22    M21    A21    M22    A23

DR3

DR1

DR2

# FIG. 4D

EP 4 321 930 A1

# FIG. 5

G2-1

M21-1  A21  M22-1

21
21'
A22 { 23
22'
22

24
23'
26  } A23
24'
25

DR2
DR5  DR4
DR3  DR1

EP 4 321 930 A1

# FIG. 6A

EP 4 321 930 A1

# FIG. 6B

EP 4 321 930 A1

FIG. 7A

# FIG. 7B

EP 4 321 930 A1

FIG. 7C

# FIG. 8A

CC'

M43  P43  M44

45  47

P44 { 43'  44' } P45

46  48

G4

P41  P42

d2"

M41
M42
M43
M44 } M4

42  44

A42 { 41'  42' } A43

41  43

d1"

S

A41
A42
A43
P41
P42
P43
P44
P45 } A4

M41  A41  M42

DR2
DR5  DR4
DR1
DR3

EP 4 321 930 A1

# FIG. 8B

EP 4 321 930 A1

# FIG. 8C

# FIG. 9A

EP 4 321 930 A1

# FIG. 9B

EP 4 321 930 A1

Europäisches
Patentamt

European
Patent Office

Office européen
des brevets

# EUROPEAN SEARCH REPORT

Application Number

EP 23 18 9747

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/365985 A1 (ISHII HIROYUKI [JP] ET AL) 11 December 2014 (2014-12-11) | 1-9, 12-20, 22-24 | INV. G03F1/32 G03F1/36 |
| Y | * column 1, line 14 - column 34, line 27 * * figures 1,10-12,35,39 * | 10,11,21 | G03F7/00 |
| Y | US 5 700 601 A (HASEGAWA NORIO [JP] ET AL) 23 December 1997 (1997-12-23) | 10,11 | |
| A | * paragraph [0079] - paragraph [0085] * * figure 9 * | 1,24 | |
| Y | US 6 355 382 B1 (YASUZATO TADAO [JP] ET AL) 12 March 2002 (2002-03-12) | 21 | |
| A | * column 12, line 65 - column 13, line 62 * * figure 7 * | 1,24 | |

TECHNICAL FIELDS
SEARCHED       (IPC)

G03F

The present search report has been drawn up for all claims

| Place of search | Date of completion of the search | Examiner |
|---|---|---|
| Munich | 20 December 2023 | Meixner, Matthias |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 18 9747

This annex lists the patent family members relating to the patent documents cited in the above-mentioned European search report.
The members are as contained in the European Patent Office EDP file on
The European Patent Office is in no way liable for these particulars which are merely given for the purpose of information.

20-12-2023

| Patent document cited in search report | | Publication date | Patent family member(s) | | Publication date |
|---|---|---|---|---|---|
| US 2014365985 | A1 | 11-12-2014 | CN | 104238261 A | 24-12-2014 |
| | | | JP | 6192372 B2 | 06-09-2017 |
| | | | JP | 2014240899 A | 25-12-2014 |
| | | | KR | 20140144661 A | 19-12-2014 |
| | | | TW | 201447476 A | 16-12-2014 |
| | | | US | 2014365985 A1 | 11-12-2014 |
| US 5700601 | A | 23-12-1997 | CN | 1118457 A | 13-03-1996 |
| | | | CN | 1423168 A | 11-06-2003 |
| | | | KR | 960002536 A | 26-01-1996 |
| | | | US | 5700601 A | 23-12-1997 |
| | | | US | 5895741 A | 20-04-1999 |
| US 6355382 | B1 | 12-03-2002 | JP | 3275863 B2 | 22-04-2002 |
| | | | JP | 2000206667 A | 28-07-2000 |
| | | | KR | 20000057725 A | 25-09-2000 |
| | | | US | 6355382 B1 | 12-03-2002 |

EPO FORM P0459

For more details about this annex : see Official Journal of the European Patent Office, No. 12/82